# EUROPEAN PATENT APPLICATION

(11) **EP 4 815 657 A1**
(43) Date of publication of application: **30.09.2026**
(21) Application number: 23961201.3
(22) Date of filing: 15.12.2023
(51) Int. Cl.: H10B 12/00

(54) **MEMORY ARRAY, MANUFACTURING METHOD THEREFOR, MEMORY AND ELECTRONIC DEVICE**

(71) Applicant: Huawei Technologies Co., Ltd., Shenzhen, Guangdong 518129 (CN)
(72) Inventor: GU, Junxing, Shenzhen, Guangdong 518129 (CN); LV, Hangbing, Shenzhen, Guangdong 518129 (CN); XU, Yannan, Shenzhen, Guangdong 518129 (CN); WANG, Chao, Shenzhen, Guangdong 518129 (CN); ZHAO, Weijie, Shenzhen, Guangdong 518129 (CN); WANG, Xiao, Shenzhen, Guangdong 518129 (CN); SU, Diqing, Shenzhen, Guangdong 518129 (CN); LI, Shaorui, Shenzhen, Guangdong 518129 (CN); DU, Kai, Shenzhen, Guangdong 518129 (CN)
(74) Representative: Körber, Martin Hans
(86) International application number: PCT/CN2023/139209
(87) International publication number: WO 2025/123345

(57) **Abstract**

Embodiments of this application provide a memory array and a manufacturing method thereof, a memory, and an electronic device, and relate to the field of semiconductor storage technologies, to reduce a size of the memory without affecting a capacity of the memory. The memory array includes a substrate, a transistor chain, a capacitor array, and an electrical connection structure. The transistor chain includes a plurality of transistors connected in series. In the capacitor array, a vertical projection of one columnar capacitor on the transistor chain overlaps a first electrode or a second electrode of one transistor. The transistor chain and a columnar capacitor electrically connected to the transistor chain form a chain storage architecture. Electrodes of two adjacent columnar capacitors electrically connected to a same transistor chain are respectively electrically connected to two ends of the electrical connection structure, to enable the two adjacent columnar capacitors to be connected in series through the electrical connection structure. The electrical connection structure does not occupy a spacing between the two adjacent columnar capacitors, so that the spacing between the two adjacent columnar capacitors is the same as or approximately the same as a spacing between the first electrode and the second electrode of the transistor.

## Description

### TECHNICAL FIELD

This application relates to the field of semiconductor storage technologies, and in particular, to a memory array and a manufacturing method thereof, a memory, and an electronic device.

### BACKGROUND

As a user has increasingly higher requirements on function diversification of an electronic device, an information processing amount of the electronic device is increasingly large, which requires a memory in the electronic device to have a larger storage capacity. A memory cell of the memory, for example, a dynamic random access memory (dynamic random access memory, DRAM), may include a transistor and a capacitor, and the capacitor is configured to store information. A capacity of the capacitor needs to meet a specific requirement to match an information processing requirement of the electronic device. However, generally, a capacity of the capacitor is directly proportional to a size of the capacitor. The size of the capacitor increases as the capacity of the capacitor increases, making it impossible to satisfy the integration requirement of the electronic device.

### SUMMARY

This application provides a memory array and a manufacturing method thereof, a memory, and an electronic device, to reduce a size of the memory without affecting a capacity of the memory.

To achieve the foregoing objective, this application uses the following technical solutions.

According to an aspect of this application, a memory array is provided. The memory array includes a substrate, a transistor chain, a capacitor array, and at least one electrical connection structure. At least a part of at least two transistor chains is disposed in the substrate, and the transistor chain includes a plurality of transistors connected in series. In a same transistor chain, first electrodes or second electrodes of two adjacent transistors are shared, to enable the two adjacent transistors to be connected in series. The capacitor array is stacked on a side that is of the transistor chain and that faces away from the substrate, and the capacitor array includes a plurality of columnar capacitors. A vertical projection of one columnar capacitor on the transistor chain at least partially overlaps a first electrode or a second electrode of one transistor. In addition, two electrodes of the columnar capacitor are respectively electrically connected to the first electrode and the second electrode of the transistor, to form a memory cell. On this basis, the at least one electrical connection structure is stacked on a side that is of the capacitor array and that faces away from the transistor chain. Electrodes of two adjacent columnar capacitors electrically connected to a same transistor chain are respectively electrically connected to two ends of the electrical connection structure, to enable the two adjacent columnar capacitors to be connected in series through the electrical connection structure.

In conclusion, first electrodes or second electrodes of two adjacent transistors are shared, so that a plurality of transistors can be connected in series to form the foregoing transistor chain. In addition, two electrodes of the columnar capacitor are respectively electrically connected to a first electrode and a second electrode of a same transistor, so that one transistor and one columnar capacitor electrically connected to the first electrode and the second electrode of the transistor can form one memory cell. In this case, the transistor chain and a columnar capacitor electrically connected to the transistor chain may form a chain storage architecture. Compared with a 1T1C (one transistor and one capacitor) structure used by a conventional DRAM, the chain storage architecture has a more compact arrangement of memory cells. This helps reduce a size of a memory array and a size of a memory having the memory array. In addition, compared with a planar capacitor, in a same horizontal plane (for example, a bearing surface of a substrate of a memory capacitor), when capacitances are the same, the columnar capacitor occupies a smaller area than the planar capacitor, so that, when a capacity of the memory is not affected, a size of the memory cell can be reduced, and a size of the memory array and a size of the memory having the memory array can be further reduced. On this basis, a vertical projection of one columnar capacitor on the transistor chain at least partially overlaps a first electrode or a second electrode of one transistor. In addition, an electrical connection structure configured to connect two adjacent columnar capacitors in series in the chain storage architecture is disposed on a side that is of the capacitor array and that faces away from the transistor chain, so that the electrical connection structure can be prevented from occupying a spacing between the two adjacent columnar capacitors, and the spacing between the two adjacent columnar capacitors may be the same as or approximately the same as the spacing (twice the minimum processing size F of a semiconductor) between the first electrode and the second electrode of the transistor. In this way, a single-side size of the memory cell may reach 2F, so that an area of the entire memory cell can reach 4F², thereby reducing the size of the memory cell, and further reducing sizes of the memory array and the memory having the memory array.

In an optional implementation, the columnar capacitor includes a first columnar electrode, a second columnar electrode, and a dielectric layer. An end that is of the first columnar electrode and that faces the transistor chain is electrically connected to the first electrode or the second electrode of the transistor. At least a part of the second columnar electrode is disposed in the first columnar electrode. At least a part of the dielectric layer is disposed in the first columnar electrode, and the dielectric layer is located between the first columnar electrode and the second columnar electrode. The two adjacent columnar capacitors electrically connected to the same transistor chain are a first columnar capacitor and a second columnar capacitor. In addition, two ends of the electrical connection structure are respectively electrically connected to the second columnar electrode of the first columnar capacitor and the first columnar electrode of the second columnar capacitor. In this way, the two adjacent columnar capacitors electrically connected to the same transistor chain, for example, the first columnar capacitor and the second columnar capacitor, may be electrically connected through the electrical connection structure.

In an optional implementation, the memory array further includes a first insulation layer, and the first insulation layer covers the capacitor array. In addition, the electrical connection structure includes a first via, a second via, and a first conduction portion. The first via penetrates the first insulation layer. A first end of the first via is electrically connected to the second columnar electrode of the first columnar capacitor. The second via penetrates the first insulation layer. A first end of the second via is electrically connected to the first columnar electrode of the second columnar capacitor. The first conduction portion is disposed on a side that is of the first insulation layer and that faces away from the capacitor array. Two ends of the first conduction portion are respectively electrically connected to a second end of the first via and a second end of the second via. In this way, the first via, the second via, and the first conduction portion that are electrically connected to each other may form an electrical connection structure. Two ends of the electrical connection structure may be respectively electrically connected to the second columnar electrode of the adjacent first columnar capacitor and the first columnar electrode of the adjacent second columnar capacitor, so that two adjacent columnar capacitors electrically connected to a same transistor chain are electrically connected through the electrical connection structure 40.

In an optional implementation, in any one of the first columnar capacitor and the second columnar capacitor, an end that is of the second columnar electrode and that faces the electrical connection structure extends out of the first columnar electrode. In addition, the memory array further includes a first insulation layer, and the first insulation layer covers the capacitor array. The electrical connection structure includes a third via and a second conduction portion. The third via penetrates the first insulation layer. A first end of the third via is electrically connected to the first columnar electrode of the second columnar capacitor. The second conduction portion is disposed on a side that is of the first insulation layer and that faces away from the capacitor array. Two ends of the second conduction portion are respectively electrically connected to an end that is of the second columnar electrode of the first columnar capacitor and that faces the electrical connection structure and a second end of the third via. In this way, the second columnar electrode of the first columnar capacitor may be indirectly electrically connected to the first columnar electrode of the second columnar capacitor sequentially through the second conduction portion and the third via. In addition, only one via, namely, the third via, is disposed between the two adjacent columnar capacitors electrically connected to the same transistor chain, for example, the first columnar capacitor and the second columnar capacitor. Therefore, a spacing between two adjacent third vias is large, and a requirement on precision of a photolithography process for manufacturing the third vias is low, so that manufacturing processes of the memory array and the memory can be simplified. The photolithography process may include a process used to form a film layer pattern, for example, exposure, development, and etching.

In an optional implementation, the memory array further includes a second insulation layer and an electrical connection column. The second insulation layer is disposed on the side that is of the transistor chain and that faces away from the substrate. The capacitor array is embedded in the second insulation layer. The electrical connection column is disposed in the second insulation layer. The electrical connection column is located on a side that is of the third via and that faces away from the second conduction portion, and the electrical connection column is electrically connected to a side wall of the first columnar electrode and the third via. In this way, because the electrical connection column is electrically connected to the side wall of the first columnar electrode, a probability of an electrical connection between the third via and the first columnar electrode can be increased via the electrical connection column, to ensure reliability of the electrical connection.

In an optional implementation, the columnar capacitor includes a first columnar electrode, a second columnar electrode, and a dielectric layer. At least a part of the second columnar electrode is disposed in the first columnar electrode. At least a part of the dielectric layer is disposed in the first columnar electrode, and the dielectric layer is located between the first columnar electrode and the second columnar electrode. The two adjacent columnar capacitors electrically connected to the same transistor chain are a first columnar capacitor and a second columnar capacitor. The first columnar electrode of the first columnar capacitor and the first columnar electrode of the second columnar capacitor are connected to form an integrated mechanical member. An end that is of the integrated mechanical member and that faces the transistor chain is electrically connected to the first electrode of the transistor. The second columnar electrode of the first columnar capacitor penetrates the integrated mechanical member and is electrically connected to the second electrode of the transistor. A side that is of the integrated mechanical member and that faces away from the transistor chain is provided with a first blind via, and the second columnar electrode of the second columnar capacitor is located in the first blind via. The at least one electrical connection structure includes a first electrical connection structure. In adjacent integrated mechanical members, the second columnar electrode of the second columnar capacitor and the second columnar electrode of the first columnar capacitor are respectively electrically connected to two ends of the first electrical connection structure. In this way, an end that is of the integrated mechanical member and that faces the transistor chain is electrically connected to the first electrode of the transistor, so that one electrode of the transistor configured to form the memory cell, for example, the source electrode, can be electrically connected to one electrode of the columnar capacitor, for example, the first columnar electrode. In addition, the other electrode of the transistor configured to form the memory cell, for example, the drain electrode, is electrically connected to the other electrode of the columnar capacitor, for example, the second columnar electrode. In addition, two adjacent columnar capacitors that are electrically connected to a same transistor chain and that have different integrated mechanical members may be further connected in series through the first electrical connection structure.

In an optional implementation, the memory array further includes a first insulation layer, and the first insulation layer covers the capacitor array. The adjacent integrated mechanical members are a first integrated mechanical member and a second integrated mechanical member, and the first electrical connection structure includes a fourth via, a fifth via, and a third conduction portion. The fourth via penetrates the first insulation layer. A first end of the fourth via is electrically connected to the second columnar electrode of the second columnar capacitor in the first integrated mechanical member. The fifth via penetrates the first insulation layer. A first end of the fifth via is electrically connected to the second columnar electrode of the first columnar capacitor in the second integrated mechanical member. The third conduction portion is disposed on a side that is of the first insulation layer and that faces away from the capacitor array. Two ends of the third conduction portion are respectively electrically connected to a second end of the fourth via and a second end of the fifth via. In this way, in adjacent integrated mechanical members, the second columnar electrode of the second columnar capacitor in the first integrated mechanical member may be electrically connected to the second columnar electrode of the first columnar capacitor in the second integrated mechanical member sequentially through the fourth via, the third conduction portion, and the fifth via.

In an optional implementation, in the columnar capacitor, an end that is of the second columnar electrode and that faces away from the transistor chain extends out of the first columnar electrode. The capacitor array includes a plurality of integrated mechanical members, and two ends of the first electrical connection structure are respectively electrically connected to ends that are of two adjacent second columnar electrodes in different integrated mechanical members and that face away from the transistor chain. In this way, two adjacent columnar capacitors having different integrated structures, for example, the first columnar capacitor and the second columnar capacitor, may be connected in series through the first electrical connection structure.

In an optional implementation, in the transistor chain, a columnar capacitor electrically connected to the transistor at the tail end or the head end is a third columnar capacitor. A side that is of the third columnar capacitor and that faces away from the transistor chain is provided with a second blind via, and the second columnar electrode of the third columnar capacitor is located in the second blind via. In addition, the at least one electrical connection structure further includes a second electrical connection structure, and the second columnar electrode of the third columnar capacitor and the second columnar electrode of the adjacent first columnar capacitor or second columnar capacitor are respectively electrically connected to two ends of the second electrical connection structure. In this way, the third columnar capacitor may be electrically connected to the first columnar capacitor or the second columnar capacitor adjacent to the third columnar capacitor through the second electrical connection structure. A structure of the second electrical connection structure may be similar to that of the first connection structure. Details are not described herein again.

In an optional implementation, the dielectric layer includes a ferroelectric thin film layer. In this case, the columnar capacitor may be a ferroelectric capacitor, and a memory having the ferroelectric capacitor may be a ferroelectric random access memory. The ferroelectric random access memory has a feature of low leakage current and high density. Alternatively, the dielectric layer includes a resistive switching layer. In this case, the columnar capacitor may be a resistive capacitor, and a memory having the resistive switching capacitor may be a resistive random access memory.

In an optional implementation, the first electrode or the second electrode of the transistor is located within a range of a vertical projection of the columnar capacitor on the transistor chain, so that a spacing between the first electrode and the second electrode of the transistor occupied by the columnar capacitor can be reduced.

In an optional implementation, the columnar capacitor may be located right above the first electrode or the second electrode of the transistor. In this case, a center of the columnar capacitor may overlap or approximately overlap a center of the first electrode or the second electrode of the transistor. In this way, reduce a spacing between the first electrode and the second electrode of the transistor occupied by the columnar capacitor is reduced.

In an optional implementation, the first electrode and the second electrode of the transistor are disposed in the substrate. The memory array further includes a first electrode line, and the first electrode line is electrically connected to a gate of the transistor. The first electrode line is disposed on a surface of a side that is of the substrate and that faces the capacitor array; or the first electrode line is disposed in the substrate. When the first electrode line is disposed in the substrate, and the first electrode line is electrically connected to or shared with the gate of the transistor, a length of a channel between the first electrode and the second electrode of the transistor may be increased. In addition, because the first electrode line is located in the substrate, a size of the entire memory array occupied by the first electrode line in the thickness direction of the memory can be reduced.

In an optional implementation, the memory array further includes a second electrode line and a third electrode line. A first end of one transistor chain is electrically connected to the second electrode line. The third electrode line is electrically connected to second ends of the at least two transistor chains. In this way, one or more of the electrically connected first electrode line, second electrode line, and third electrode line are configured to select, by receiving a control level output by a control circuit, a to-be-read/written memory cell in the memory array, to implement data reading/writing.

In an optional implementation, the memory array further includes a contact portion. The contact portion is disposed between the transistor chain and the capacitor array. The contact portion is electrically connected to an electrode of the columnar capacitor and the first electrode or the second electrode of the transistor. In this way, the electrode of the columnar capacitor can be accurately electrically connected to the first electrode or the second electrode of the transistor T through the contact portion.

In an optional implementation, the plurality of columnar capacitors electrically connected to the at least two transistor chains are arranged in a matrix manner. In this case, on a premise that a spacing between two adjacent first electrode lines, for example, word lines, meets a process requirement, for example, a minimum processing size, a size of the columnar capacitor in the bearing surface of the substrate may be reduced, to reduce a spacing between columnar capacitors respectively electrically connected to two adjacent transistor chains. In this way, memory cells in the memory array can be arranged more closely, so that a memory having the memory array has a feature of high density. Alternatively, the plurality of columnar capacitors electrically connected to the at least two transistor chains are arranged in a cellular manner. In this case, in the two adjacent transistor chains, a columnar capacitor electrically connected to one transistor chain may be located between two adjacent columnar capacitors electrically connected to the other transistor chain, so that arrangement of the plurality of transistor chains can be more compact. In addition, on a premise that a spacing between columnar capacitors respectively electrically connected to two adjacent transistor chains meets a process requirement, for example, a minimum processing size, a size of the columnar capacitor in the bearing surface of the substrate may be increased. This helps increase a capacity of the memory array and a capacity of a memory having the memory array.

According to another aspect of this application, a memory is provided. The memory includes any one of the foregoing memory arrays and the memory. The controller is electrically connected to the memory array, and the controller is configured to control read/write of the memory array. The memory has the same technical effect as the memory array provided in the foregoing embodiments. Details are not described herein again.

According to another aspect of this application, an electronic device is provided. The electronic device includes a circuit board and any memory described above, and the circuit board is electrically connected to the memory. The electronic device has the same technical effect as the memory array provided in the foregoing embodiments. Details are not described herein again.

According to another aspect of this application, a manufacturing method of a memory array is provided. The method includes: First, at least a part of a plurality of transistors is formed in a substrate. First electrodes or second electrodes of two adjacent transistors are shared, to enable the two adjacent transistors to be connected in series, to form a transistor chain. Next, a plurality of columnar capacitors are formed. A vertical projection of one columnar capacitor on the transistor chain at least partially overlaps a first electrode or a second electrode of one transistor. Two electrodes of the columnar capacitor are respectively electrically connected to the first electrode and the second electrode of the transistor, to form a memory cell. Next, at least one electrical connection structure is formed on a side that is of the plurality of columnar capacitors and that faces away from the transistor chain. Two ends of the electrical connection structure are respectively electrically connected to electrodes of two adjacent columnar capacitors electrically connected to a same transistor chain, to enable the two adjacent columnar capacitors to be connected in series through the electrical connection structure. The manufacturing method of the memory array has the same technical effect as the memory array provided in the foregoing embodiment. Details are not described herein again.

In an optional implementation, forming any one of the plurality of columnar capacitors includes: First, a first columnar electrode is formed. Next, a dielectric layer is formed in the first columnar electrode. Next, a second columnar electrode is formed in the dielectric layer. The dielectric layer is located between the first columnar electrode and the second columnar electrode. The two adjacent columnar capacitors electrically connected to the same transistor chain are a first columnar capacitor and a second columnar capacitor. That the electrical connection structure is formed includes: respectively electrically connecting two ends of the electrical connection structure to the second columnar electrode of the first columnar capacitor and the first columnar electrode of the second columnar capacitor. Technical effect of a manner in which the electrical connection structure is electrically connected to the first columnar capacitor and the second columnar capacitor is the same as that described above. Details are not described herein again.

In an optional implementation, the two adjacent columnar capacitors electrically connected to the same transistor chain are a first columnar capacitor and a second columnar capacitor. That the first columnar capacitor and the second columnar capacitor are formed includes: First, the first columnar electrode of the first columnar capacitor and the first columnar electrode of the second columnar capacitor are formed, and the first columnar electrode of the first columnar capacitor and the first columnar electrode of the second columnar capacitor are connected to form an integrated mechanical member. Next, an end that is of the integrated mechanical member and that faces the transistor chain is electrically connected to the first electrode of the transistor. Next, a through hole that penetrates the integrated mechanical member is manufactured in the integrated mechanical member, a second columnar electrode of the first columnar capacitor is formed in the through hole, and the second columnar electrode is electrically connected to the second electrode of the transistor. Next, a first blind via is formed on a side that is of the integrated mechanical member and that faces away from the transistor chain, and the second columnar electrode of the second columnar capacitor is formed in the first blind via. Next, that the at least one electrical connection structure is formed includes: A first electrical connection structure is formed on a side that is of the plurality of columnar capacitors and that faces away from the transistor chain, and two ends of the first electrical connection structure are respectively electrically connected to the second columnar electrode of the second columnar capacitor and the second columnar electrode of the first columnar capacitor in the adjacent integrated mechanical members. Technical effect of a manner in which the electrical connection structure is electrically connected to the first columnar capacitor and the second columnar capacitor is the same as that described above. Details are not described herein again.

### BRIEF DESCRIPTION OF DRAWINGS

FIG. 1 is a diagram of a structure of an electronic device according to an embodiment of this application;
FIG. 2 is a diagram of a structure of a memory according to an embodiment of this application;
FIG. 3 is a diagram of another structure of the memory in FIG. 2;
FIG. 4A is a diagram of a structure of a memory cell in FIG. 3;
FIG. 4B is a diagram of a chain storage architecture according to an embodiment of this application;
FIG. 4C is a diagram of another chain storage architecture according to an embodiment of this application;
FIG. 5A is a diagram of a structure of a columnar capacitor according to an embodiment of this application;
FIG. 5B is a diagram of another structure of a columnar capacitor according to an embodiment of this application;
FIG. 6 is a diagram of a structure of a memory array according to an embodiment of this application;
FIG. 7 is a diagram of another structure of a memory array according to an embodiment of this application;
FIG. 8 is a diagram of another structure of a memory array according to an embodiment of this application;
FIG. 9 is a top view of a structure obtained in a direction A in FIG. 8;
FIG. 10 is a flowchart of a manufacturing method of a memory array according to an embodiment of this application;
FIG. 11A, FIG. 11B, FIG. 11C, and FIG. 11D are diagrams of structures obtained by separately performing at least a part of the manufacturing method shown in FIG. 10;
FIG. 12 is a diagram of another structure of a memory array according to an embodiment of this application;
FIG. 13A is a top view of a structure obtained in a direction B in FIG. 7 or FIG. 12;
FIG. 13B is a top view of another structure obtained in a direction B in FIG. 7 or FIG. 12;
FIG. 14A is a diagram of another structure of a memory array according to an embodiment of this application;
FIG. 14B is a diagram of another structure of a memory array according to an embodiment of this application;
FIG. 15 is a diagram of another structure of a memory array according to an embodiment of this application;
FIG. 16A is a top view of a structure obtained in a direction C in FIG. 15;
FIG. 16B is a top view of another structure obtained in a direction C in FIG. 15;
FIG. 16C is a top view of another structure obtained in a direction C in FIG. 15;
FIG. 17 is a top view of another structure obtained in a direction C in FIG. 15;
FIG. 18 is a diagram of another structure of a memory array according to an embodiment of this application;
FIG. 19 is a diagram of another structure of a memory array according to an embodiment of this application;
FIG. 20 is a diagram of another structure of a memory array according to an embodiment of this application;
FIG. 21 is a diagram of another structure of a memory array according to an embodiment of this application;
FIG. 22A and FIG. 22B are diagrams of structures obtained by separately performing at least a part of the manufacturing method shown in FIG. 10;
FIG. 23 is a diagram of another structure of a memory array according to an embodiment of this application;
FIG. 24A is a top view of a structure obtained in a direction D in FIG. 19;
FIG. 24B is a top view of another structure obtained in a direction D in FIG. 19; and
FIG. 25 is a diagram of another structure of a memory array according to an embodiment of this application.

### Reference numerals:

01: electronic device; 100: PCB; 101: bus; 102: SoC; 103: second RAM; 104: communication chip; 105: power management chip; 112: AP; 122: GPU; 132: first RAM; 20: memory; 21: memory array; 22: controller; 210: memory cell; 220: decoder; 230: driver; 240: timing controller; 250: buffer; 260: input/output driver; 2100: transistor chain; 300: capacitor array; 200: substrate; 30: columnar capacitor; 301: first columnar electrode; 302: second columnar electrode; 303: dielectric layer; 40: electrical connection structure; 401: first via; 402: second via; 403: first conduction portion; 30a: first columnar capacitor; 30b: second columnar capacitor; 211: contact portion; 51: first insulation layer; 52: second insulation layer; 501: via; 404: third via; 405: second conduction portion; 500: hard mask; 60: electrical connection column; 70: integrated mechanical member; 70a: first integrated mechanical member; 70b: second integrated mechanical member; 30c: third columnar capacitor; 41: first electrical connection structure; 42: second electrical connection structure; 701: first blind via; 702: second blind via; 711: through hole; 411: fourth via; 412: fifth via; and 413: third conduction portion.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

The terms, such as "first" and "second", below are merely for convenience of description, and are not to be construed as indicating or implying relative importance or implicitly indicating a quantity of indicated technical features. Therefore, a feature limited by "first", "second", or the like may explicitly or implicitly include one or more features. In the descriptions of this application, unless otherwise stated, "a plurality of" means two or more than two.

In this application, unless otherwise expressly specified and limited, the term "connection" should be understood in a broad sense. For example, "connection" may be a fixed mechanical connection, or may be a detachable mechanical connection or an integrated connection, or "connection" may be a direct connection, or may be an indirect connection via an intermediate medium.

In addition, unless otherwise expressly specified and limited, the term "electrical connection" should be understood in a broad sense. For example, "electrical connection" may be a direct electrical connection, for example, two components are physically in contact and electrically connected; or may be understood as that in a line structure, different components are electrically connected through a physical line that can transmit an electrical signal, such as a printed circuit board (printed circuit board, PCB) copper foil or a conducting wire, to transmit an electrical signal. Alternatively, "electrical connection" may be an indirect electrical connection between two components via an intermediate medium. Alternatively, "electrical connection" may be an electrical connection between two components in a separated/non-contact manner. For example, two components are electrically connected in a capacitive coupling manner, to transmit an electrical signal.

In embodiments of this application, "perpendicular" and "parallel" are described to respectively represent being roughly perpendicular and being roughly parallel within an allowed error range. The error range may be a range in which a deviation angle is less than or equal to 5°, 8°, or 10° relative to being absolutely perpendicular and being absolutely parallel. This is not specifically limited herein.

In embodiments of this application, orientation terms such as "upper", "lower", "left", and "right" may include but are not limited to definitions based on illustrated orientations in which components in the accompanying drawings are placed. It should be understood that, these directional terms may be relative concepts used for relative description and clarification, and may change accordingly depending on a change in the orientations in which the components are placed in the accompanying drawings.

In the accompanying drawings of embodiments of this application, an assembly is represented by a guide line with an arrow, a component is represented by only a guide line, and an opening like a gap or a hole is represented a guide line with a wavy line at an end part.

An embodiment of this application provides an electronic device. The electronic device may be applied to various communication systems or communication protocols, for example, a Bluetooth (Bluetooth, BT) communication technology, a global positioning system (global positioning system, GPS) communication technology, a global system for mobile communications (global system for mobile communications, GSM) communication technology, a wireless fidelity (wireless fidelity, Wi-Fi) communication technology, a wideband code division multiple access (wideband code division multiple access wireless, WCDMA) communication technology, long term evolution (long term evolution, LTE), a 5G communication technology, and another future communication technology. The electronic device in embodiments of this application may be a mobile phone, a tablet computer (pad), a notebook computer, a smart home, a smart wearable device (for example, a smartwatch, a smart band, smart glasses, or a smart helmet), a virtual reality (virtual reality, VR) electronic device, an augmented reality (augmented reality, AR) electronic device, or the like. Alternatively, the electronic device may be a handheld device that has a wireless communication function, a compute device or another processing device connected to a wireless modem, a vehicle-mounted device, an electronic device in a 5G network, an electronic device in a future evolved public land mobile network (public land mobile network, PLMN), or the like. This is not limited in embodiments of this application.

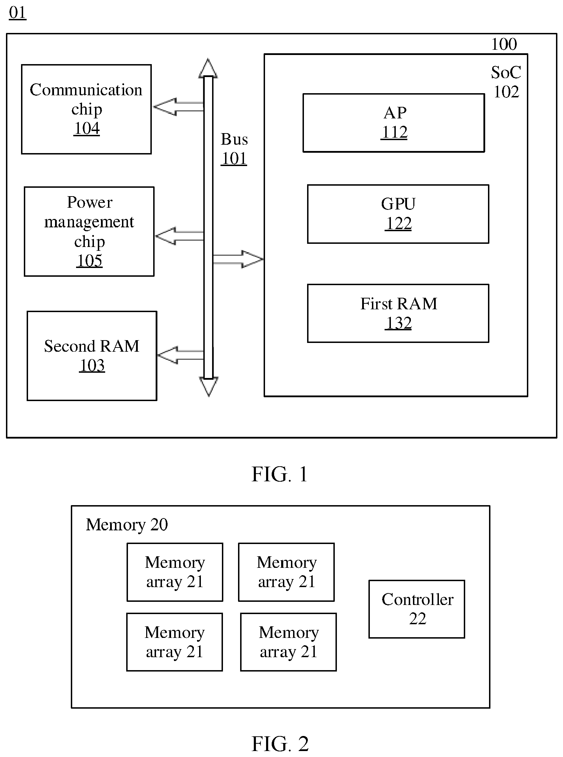

For example, as shown in FIG. 1, the electronic device 01 may include a circuit board (for example, the PCB) 100, a bus 101 disposed on the PCB 100 and electrically connected to the PCB 100, and a processor connected to the bus 101, for example, a system on chip (system on chip, SoC) 102. The SoC 102 may be configured to process data, for example, process data of an application, process image data, and buffer temporary data. In an implementation, the SoC 102 may include an application processor (application processor, AP) 112 configured to process the application, a graphics processing unit (Graphics Processing Unit, GPU) 122 configured to process the image data, and a first RAM 132 configured to buffer high-speed data. The first RAM 132 may be a static random access memory (static random access memory, SRAM), an embedded flash (embedded flash, eflash), or the like. The AP 112, the GPU 122, and the first RAM 132 may be integrated into one die (die), or may be separately disposed in a plurality of dies.

In addition, still as shown in FIG. 1, the electronic device 01 may further include a second RAM 103 connected to the SoC 102 through the bus 101. The second RAM 103 may be a dynamic random access memory (dynamic random access memory, DRAM). The second RAM 103 may be configured to store volatile data, for example, temporary data generated by the SoC 102. A storage capacity of the second RAM 103 may be usually greater than that of the first RAM 132, but a read speed of the second RAM 103 is usually slower than that of the first RAM 132. In addition, the electronic device 01 may further include a communication chip 104 and a power management chip 105 that are connected to the SoC 102 through the bus 101. The communication chip 104 may be configured to process a protocol stack, or perform processing such as amplification and filtering on an analog radio frequency signal, or implement the foregoing functions at the same time. The power management chip 105 may be configured to supply power to another chip. In an implementation, the SoC 102 and the second RAM 103 may be packaged in a packaging structure, for example, 2.5D (dimension) or 3D packaging is used, to obtain a faster inter-chip data transmission rate.

In this case, a memory in the electronic device 01 provided in embodiments of this application may be the first RAM 132 or the second RAM 103 in FIG. 1. An application scenario of the memory is not limited in this application. In view of this, as shown in FIG. 2, the memory 20 may include memory arrays 21 and a controller 22 configured to access the memory array 21. The controller 22 is electrically connected to the memory array 21, and the controller 22 may be configured to control a read/write operation of the memory array 21.

For example, in the memory 20, the memory array 21 and the controller 22 may be two dies (dies) that are independent of each other. The memory array 21 and the controller 22 may be separately disposed on a bearing plate (for example, a package transistor chain or an adapter plate), and the memory array 21 and the controller 22 are separately electrically connected to the bearing plate. In this way, the memory array 21 and the controller 22 can implement signal transmission through a metal trace in the bearing plate. In view of this, the memory 20 having the memory array 21 may be referred to as a stand-alone (stand-alone) memory.

Alternatively, for another example, in the memory 20, the memory array 21 and the controller 22 may be two dies (dies) that are independent of each other, and the memory array 21 and the controller 22 are stacked on the bearing plate. The memory array 21 and the controller 22 may be electrically connected through a through silicon via (through silicon via, TSV) or a redistribution layer (redistribution layer, RDL), so that the memory array 21 and the controller 22 can perform signal transmission with the bearing plate. Similarly, the memory array 21 is the stand-alone memory.

Alternatively, for another example, in the memory 20, the memory array 21 and the controller 22 may be integrated into a same chip, and the integrated chip is electrically connected to the bearing plate. In view of this, the memory 20 having the memory array 21 may be referred to as an embedded memory.

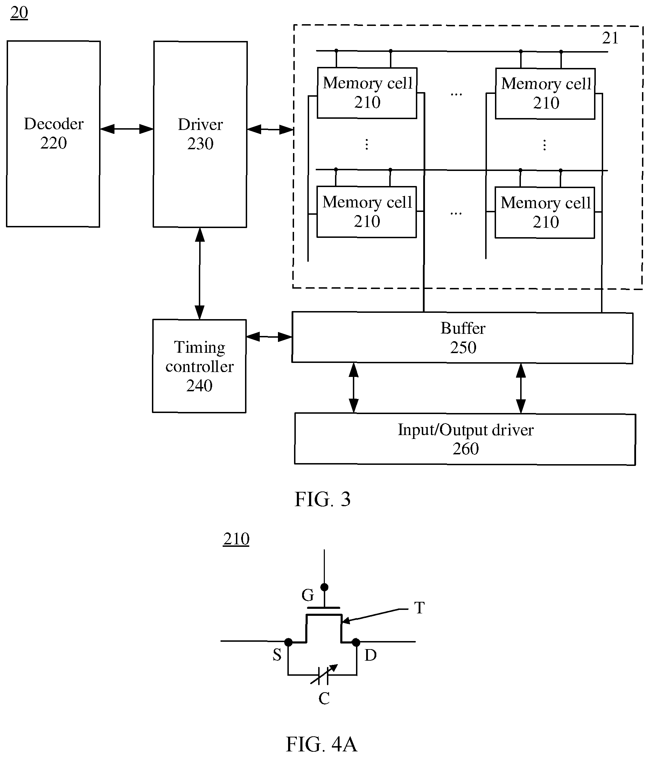

On this basis, as shown in FIG. 3, the memory array 21 may include a plurality of memory cells (cell) 210, and each memory cell 210 may be configured to store 1-bit (bit) or multibit data. For example, still as shown in FIG. 4A, the memory cell 210 may include a transistor T and a capacitor C. Two ends of the capacitor C may be respectively connected to a first electrode, for example, a source (source, S), and a second electrode, for example, a drain (drain, D) of the transistor T; or respectively connected to a first electrode (for example, a drain D) and a second electrode (for example, a source S) of the transistor T. For ease of description, the following uses an example in which the first electrode of the transistor T is the source S and the second electrode is the drain D for description.

FIG. 4A is merely an example for description in which the memory cell 210 of the memory array 21 is 1T1C (that is, one transistor T and one memory capacitor C). A quantity of transistors and a quantity of memory capacitors in the memory cell 210 are not limited in embodiments of this application. In addition, the controller 22 in FIG. 2 may include one or more circuit structures in a decoder 220, a driver 230, a timing controller 240, a buffer 250, or an input/output driver 260 shown in FIG. 3. The decoder 220 is configured to decode an address of the memory cell 210. The decoder 220 is configured to perform decoding based on a received address, to determine a memory cell 210 that needs to be accessed. The driver 230 is configured to control a level of a signal line based on a decoding result generated by the decoder 220, to access the specified memory cell 210. The buffer 250 is configured to buffer read data, for example, may buffer the data in a first-in first-out (first-in first-out, FIFO) manner. The timing controller 240 is configured to: control timing of the buffer 250, and control timing of the driver 230 for driving a signal line in the memory cell 210. The input/output driver 260 is configured to drive a transmission signal, for example, drive a received data signal and drive a data signal that needs to be sent, so that the data signals can be transmitted over a long distance. The memory array 21, the decoder 220, the driver 230, the timing controller 240, the buffer 250, and the input/output driver 260 may be integrated into one chip, or may be respectively integrated into a plurality of chips.

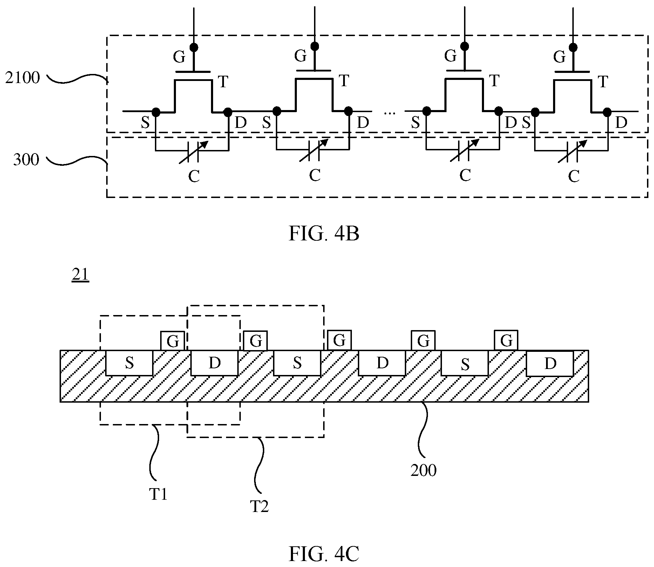

Based on this, in some embodiments of this application, the memory 20 may be a chain cell (chain cell). In this case, as shown in FIG. 4B, the memory array 21 may include at least two transistor chains 2100 (one transistor chain 2100 is used as an example in FIG. 4B). The transistor chain 2100 may include at least two transistors T connected in series. In two adjacent transistors T in a same transistor chain 2100, one electrode, for example, a source S or a drain D, of one transistor T is electrically connected to one electrode, for example, a drain D or a source S, of the other transistor T. In this way, the two adjacent transistors T in the transistor chain 2100 are connected in series.

The transistor T may be a metal-oxide-semiconductor field-effect transistor (metal-oxide-semiconductor field-effect transistor, MOSFET). Based on this, to enable the plurality of transistors T in the transistor chain 2100 to be connected in series, as shown in FIG. 4C, the memory array 21 may further include a substrate 200. For example, the substrate 200 may be a semiconductor substrate, for example, a silicon (Si) substrate. In a process of manufacturing the transistor chain 2100 (as shown in FIG. 4B), a first electrode (for example, a source S) and a second electrode (for example, a drain D) of a transistor may be formed in the substrate 200 by using a doping process. First electrodes (for example, source electrodes S) or second electrodes (for example, drain electrodes D) of two adjacent transistors are shared.

For example, still as shown in FIG. 4C, two adjacent transistors may be a transistor T1 and a transistor T2. That a second electrode (for example, a drain D) of the transistor T1 and a second electrode (for example, a drain D) of the transistor T2 are shared means that a second electrode (for example, the drain D) between the transistor T1 and the transistor T2 may be used as the second electrode of the transistor T1, or may also be used as the second electrode of the transistor T2. In this way, the second electrode (for example, the drain D) of the transistor T1 may be electrically connected to the second electrode (for example, the drain D) of the transistor T2, so that the transistor T1 and the transistor T2 are connected in series.

The foregoing describes an example in which the transistor T1 and the transistor T2 are connected in series by using an example in which the second electrode (for example, the drain D) of the transistor T1 and the second electrode (for example, the drain D) of the transistor T2 are shared. In some other embodiments of this application, a first electrode (for example, a source S) of the transistor T1 and a first electrode (for example, a source S) of the transistor T2 are shared, or the transistor T1 and the transistor T2 may be connected in series. In addition, a serial connection manner of other transistors in the transistor chain 2100 (as shown in FIG. 4B) is the same as that described above, and details are not described herein again.

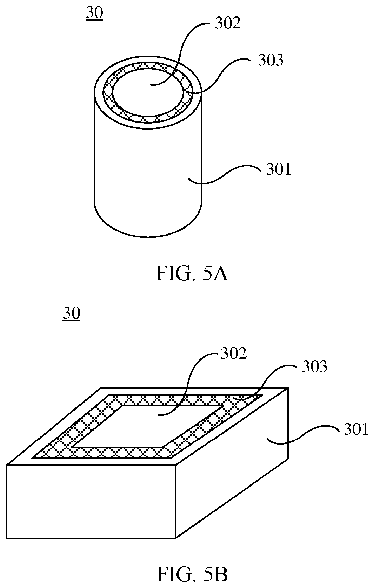

In addition, it can be learned from the foregoing that, as shown in FIG. 4B, each transistor T is electrically connected to one capacitor C, and a plurality of capacitors C may form a capacitor array 300. In the transistor chain 2100, a first electrode and a second electrode of each transistor T are electrically connected to two ends of one capacitor C, and two adjacent transistors T are connected in series. Therefore, a plurality of capacitors C electrically connected to a same transistor chain 2100 may also be connected in series. The capacitor C may be a columnar capacitor 30 shown in FIG. 5A or FIG. 5B. The columnar capacitor 30 shown in FIG. 5A may be a cylinder, and the columnar capacitor 30 shown in FIG. 5B may be a cube. A shape of the columnar capacitor 30 is not limited in this application. For ease of description, the following uses an example in which the columnar capacitor 30 is a cylinder shown in FIG. 5A.

Still as shown in FIG. 5A, the columnar capacitor 30 may include a first columnar electrode 301, a second columnar electrode 302, and a dielectric layer 303. At least a part of the second columnar electrode 302 is disposed in the first columnar electrode 301. At least a part of the dielectric layer 303 is disposed in the first columnar electrode 301, and the dielectric layer 303 is located between the first columnar electrode 301 and the second columnar electrode 302. The first columnar electrode 301 may be referred to as a bottom electrode (bottom electrode, BE), and the second columnar electrode 302 located in the first columnar electrode 301 may be referred to as a top electrode (top electrode, TE).

In some embodiments of this application, the dielectric layer 303 may be a ferroelectric thin film layer, or may be referred to as a ferroelectric dielectric layer (ferroelectric insulator). In this case, the columnar capacitor 30 may be a ferroelectric capacitor (FeCAP), and the memory 20 having the ferroelectric capacitor may be a ferroelectric random access memory (ferroelectric random access memory, FeRAM or FRAM). The FeRAM has features of low leakage current and high density.

Alternatively, in some other embodiments of this application, the dielectric layer 303 may be a resistive switching layer. In this case, the columnar capacitor 30 may be a resistive switching capacitor, and the memory 20 having the resistive switching capacitor may be a resistive random access memory (resistive random access memory, RRAM).

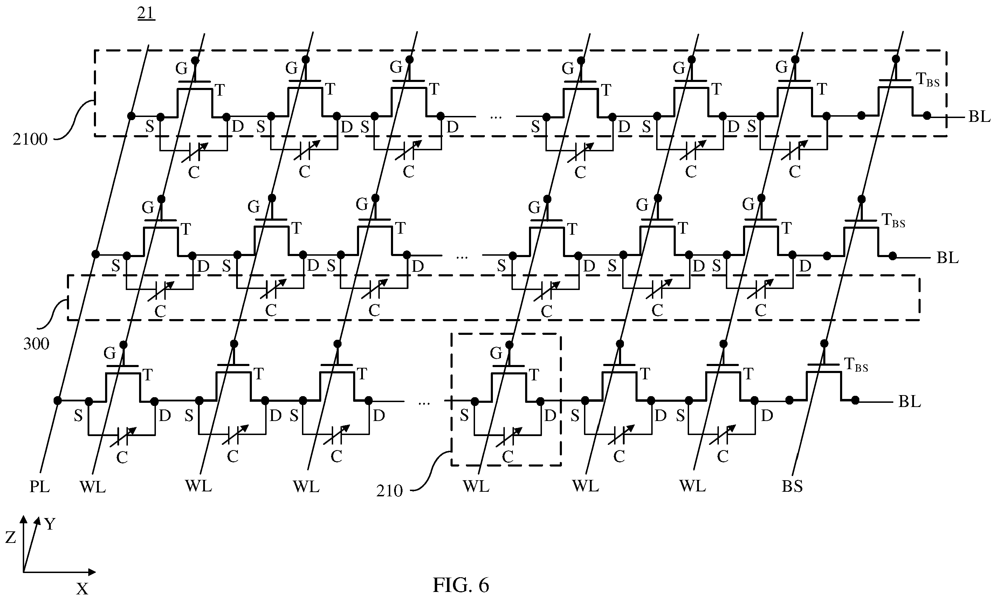

On this basis, the memory array 21 of the memory may include two or more transistor chains 2100 shown in FIG. 6. In the memory array 21, one transistor T and one capacitor C that is electrically connected to the transistor T form a memory cell 210. Therefore, a plurality of memory cells 210 in the memory array 21 including the transistor chain 2100 and the plurality of transistors T may be arranged in an array. In addition, the memory array 21 may further include a first electrode line, for example, a word line (word line, WL), a second electrode line, for example, a bit line (bit line, BL), and a third electrode line, for example, a plate line PL (plate line, PL). A gate (gate, G) of the transistor T may be electrically connected to a first electrode line, for example, a word line WL. A first end (for example, a right end) of one transistor chain 2100 may be electrically connected to one second electrode line, for example, a bit line BL. The third electrode line, for example, a plate line PL, may be electrically connected to second ends (such as left ends) of at least two transistor chains 2100.

In addition, the transistor chain 2100 may further include a gating transistor T_{BS}. A gate of the gating transistor T_{BS} is electrically connected to the control signal line BS. The control signal line BS may control the gating transistor T_{BS} to be conducted, so that the transistor chain 2100 in which the conducted gating transistor T_{BS} is located is gated.

It can be learned from the foregoing that different memory cells 210 may be electrically connected to the word line WL, the bit line BL, and the plate line PL. One or more of the word line WL, the bit line BL, and the plate line PL are configured to select, by receiving a control level output by a control circuit, a to-be-read/written memory cell 210 in the memory array 21, to change a polarization direction (up polarization or down polarization) of the capacitor C in the memory cell 210 in the ferroelectric memory, or a resistance value state (a high resistance state or a low resistance state) of the capacitor C in the resistive random access memory, so as to implement a data reading/writing operation. States corresponding to two polarization directions (up polarization and down polarization) of the capacitor C in the ferroelectric memory, or two resistance states (a high resistance state or a low resistance state) of the capacitor C in the resistive random access memory may be identified as a state of storage information "0" or "1", so as to implement a read operation of data stored in the capacitor C.

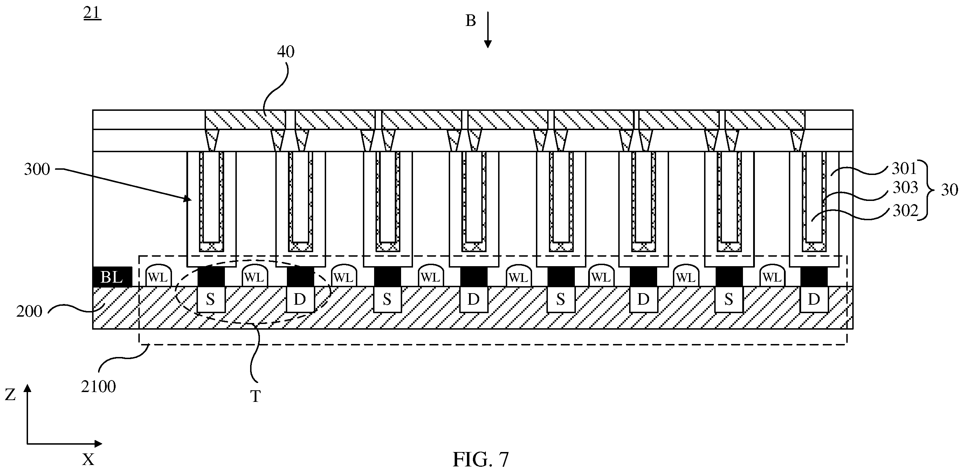

The following describes a structure of the memory array 21 having the transistor chain 2100 and the columnar capacitor 30 by using an example. It can be learned from the foregoing that, as shown in FIG. 6, the memory array 21 includes at least two transistor chains 2100 and a capacitor array 300. In some embodiments of this application, as shown in FIG. 7, at least a part of the transistor chain 2100 is disposed in the substrate 200, for example, a first electrode (for example, a source S) and a second electrode (for example, a drain D) of a transistor T in the transistor chain 2100 are disposed in the substrate 200. The capacitor array 300 is stacked on a side that is of the transistor chain 2100 and that faces away from the substrate 200.

To describe a structure of the memory array 21, the following may establish an XYZ coordinate system shown in FIG. 6. The XY plane is parallel to an upper surface (a surface used for doping to form the source and the drain of the transistor, which is referred to as a bearing surface of the substrate below) of the substrate 200 in FIG. 4C. The X direction may be an extension direction of one transistor chain 2100, the Y direction may be an arrangement direction of a plurality of transistor chains 2100, and the Z direction may be a stacking direction of the transistor chain 2100 and the capacitor array 300 (as shown in FIG. 7).

In addition, still as shown in FIG. 7, in the capacitor array 300, a vertical projection of a columnar capacitor 30 on the transistor chain 2100 at least partially overlaps a first electrode (for example, a source S) or a second electrode (for example, a drain D) of one transistor T, so that a spacing between the first electrode and the second electrode of the transistor T occupied by the columnar capacitor 30 can be reduced.

In some embodiments of this application, the first electrode (for example, the source S) or the second electrode (for example, the drain D) of the transistor T may be located within a range of the vertical projection of the columnar capacitor 30 on the transistor chain 2100. In other words, the columnar capacitor 30 may completely cover the first electrode (for example, the source S) or the second electrode (for example, the drain D) of the transistor T. For example, the columnar capacitor 30 may be located right above the first electrode (for example, the source S) or the second electrode (for example, the drain D) of the transistor T. In this case, a center (for example, an axis of the cylinder) of the columnar capacitor 30 may overlap or approximately overlap a center (for example, a geometric center) of the first electrode (for example, the source S) or the second electrode (for example, the drain D) of the transistor T. In this way, a spacing between the first electrode and the second electrode of the transistor occupied by the columnar capacitor is reduced.

Alternatively, in some other embodiments of this application, a part of the vertical projection of the columnar capacitor 30 on the transistor chain 2100 may overlap a part of the first electrode (for example, the source S) or the second electrode (for example, the drain D) of the transistor T.

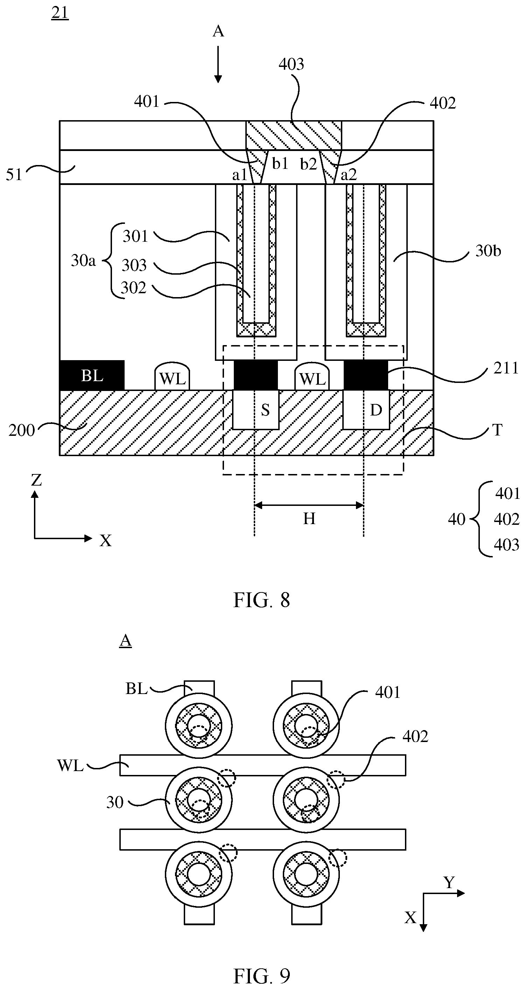

In addition, in some embodiments, a position of a gate of the transistor T, that is, the word line WL, may not overlap with a vertical projection of the columnar capacitor 30 on the transistor chain 2100, as shown in FIG. 7. Alternatively, in some other embodiments, as shown in FIG. 8, a part of the gate of the transistor T, that is, a part of a position of the word line WL, may overlap a part of a vertical projection of the columnar capacitor, for example, the first columnar capacitor 30a, on the transistor chain 2100. This is not limited in this application. The first columnar capacitor 30a and the second columnar capacitor 30b in FIG. 8 are two adjacent columnar capacitors electrically connected to a same transistor chain 2100 shown in FIG. 7.

It can be learned from the foregoing that, as shown in FIG. 8, two electrodes (the first columnar electrode 301 and the second columnar electrode 302) of a columnar capacitor, for example, the first columnar capacitor 30a or the second columnar capacitor 30b are respectively electrically connected to the first electrode (for example, the source S) or the second electrode (for example, the drain D) of a transistor T, to form a memory cell 210.

For example, as shown in FIG. 8, the first columnar electrode 301 of the first columnar capacitor 30a may be electrically connected to the first electrode (for example, the source S) of the transistor T. In some embodiments of this application, the memory array 21 may further include a contact portion 211. The contact portion 211 may be disposed between the transistor chain 2100 and the capacitor array 300 shown in FIG. 7. Still as shown in FIG. 8, one contact portion 211 is electrically connected to one columnar capacitor, for example, an electrode (for example, the first columnar electrode 301) of the first columnar capacitor 30a, and a first electrode (for example, the source S) of one transistor T, so that the first columnar electrode 301 of the first columnar capacitor 30a may be electrically connected to the first electrode (for example, the source S) of the transistor T through the contact portion 211. In this way, the electrode of the columnar capacitor 30 can be accurately electrically connected to the first electrode or the second electrode of the transistor T through the contact portion.

On this basis, to enable the second columnar electrode 302 of the first columnar capacitor 30a to be electrically connected to the second electrode (for example, the drain D) of the transistor T, and enable two adjacent columnar capacitors 30 electrically connected to a same transistor chain 2100 shown in FIG. 7 to be connected in series, the memory array 21 may further include at least one electrical connection structure 40. The electrical connection structure 40 may be stacked on a side that is of the capacitor array 300 and that faces away from the transistor chain 2100. Electrodes of the two adjacent columnar capacitors 30 electrically connected to the same transistor chain 2100 are respectively electrically connected to two ends of the electrical connection structure 40, so that the two adjacent columnar capacitors 30 electrically connected to the same transistor chain 2100 are connected in series.

For example, as shown in FIG. 8, two ends of the electrical connection structure 40 may be respectively electrically connected to the second columnar electrode 302 of the first columnar capacitor 30a and the first columnar electrode 301 of the second columnar capacitor 30b. Because the first columnar electrode 301 of the second columnar capacitor 30b is electrically connected to the second electrode (for example, the drain D) of the transistor T, the second columnar electrode 302 of the first columnar capacitor 30a may be indirectly electrically connected to the second electrode (for example, the drain D) of the transistor T through the electrical connection structure 40 and the first columnar electrode 301 of the second columnar capacitor 30b. In addition, the second columnar electrode 302 of the first columnar capacitor 30a is electrically connected to the first columnar electrode 301 of the second columnar capacitor 30b through the electrical connection structure 40, so that the adjacent first columnar capacitor 30a or second columnar capacitor 30 that are electrically connected to a same transistor chain 2100 may be electrically connected.

The foregoing uses an example in which the first columnar capacitor 30a is electrically connected to the transistor T and the first columnar capacitor 30a or the second columnar capacitor 30 is electrically connected in FIG. 8 to describe a connection manner between the columnar capacitor and the transistor, a manner in which two adjacent columnar capacitors electrically connected to a same transistor chain 2100 are connected in series is described by using an example. A manner of connecting other columnar capacitors to the transistor T and a manner of connecting other adjacent columnar capacitors in the same transistor chain 2100 in series are the same as those described above. Details are not described herein again.

In conclusion, in the memory array 21 shown in FIG. 7 provided in this embodiment of this application, first electrodes (for example, source electrodes S) or second electrodes (for example, drain electrodes D) of two adjacent transistors T are shared, so that a plurality of transistors T can be connected in series to form the transistor chain 2100. In addition, two electrodes (for example, the first columnar electrode 301 and the second columnar electrode 302) of the columnar capacitor 30 are respectively electrically connected to a first electrode (for example, a source S) or a second electrode (for example, a drain D) of a same transistor T, so that a transistor T and a columnar capacitor 30 electrically connected to the first electrode (for example, the source S) and the second electrode (for example, the drain D) of the transistor T can form a memory cell 210. In this case, the transistor chain 2100 and a columnar capacitor 30 electrically connected to the transistor chain 2100 may form a chain storage architecture. Compared with a 1T1C structure used by a conventional DRAM, the chain storage architecture has a more compact arrangement of memory cells. This helps reduce a size of a memory array and a size of a memory having the memory array, so that the memory has features of high density and a high speed.

In addition, in a data reading/writing process of the conventional DRAM, a transistor in a memory cell that participates in data reading/writing is in an on state, and a transistor in a memory cell that does not participate in data reading/writing is in an off state. In this case, there is a voltage drop at two ends of a transistor of a memory cell that does not participate in data reading/writing, and crosstalk is caused to data stored in the memory cell that does not participate in data reading/writing. In comparison, in the foregoing chain storage architecture provided in this embodiment of this application, in a data reading/writing process, a transistor in a memory cell that participates in data reading/writing is in an off state, and a transistor in a memory cell that does not participate in data reading/writing is in an on state. Therefore, there is almost no voltage drop at two ends of a transistor of a memory cell that does not participate in data reading/writing, and crosstalk is not caused to data stored in the memory cell that does not participate in data reading/writing.

On this basis, still as shown in FIG. 7, for a planar capacitor (a plane on which the capacitor electrode is located is parallel to the bearing surface of the substrate), in a same horizontal plane (for example, the bearing surface of the substrate of the memory capacitor), and with the same capacitance, the columnar capacitor 30 occupies a smaller area than the planar capacitor. Thus, when a capacity of the memory 20 is not affected, a size of the memory cell 210 can be reduced.

In addition, still as shown in FIG. 8, a vertical projection of a columnar capacitor (the first columnar capacitor 30a or the second columnar capacitor 30b) on the transistor chain 2100 overlaps a first electrode (for example, a source S) or a second electrode (for example, a drain D) of a transistor T. In addition, an electrical connection structure 40 configured to connect two adjacent columnar capacitors (for example, the first columnar capacitor 30a and the second columnar capacitor 30b) in series in the chain storage architecture is disposed on a side that is of the capacitor array 300 shown in FIG. 7 and that faces away from the transistor chain 2100, so that the electrical connection structure 40 can be prevented from occupying a spacing H between the two adjacent columnar capacitors (for example, the first columnar capacitor 30a and the second columnar capacitor 30b), and the spacing H between the two adjacent columnar capacitors (for example, the first columnar capacitor 30a and the second columnar capacitor 30b) may be the same as or approximately the same as the spacing (twice the minimum semiconductor processing size F) between the first electrode (for example, the source S) and the second electrode (for example, the drain D) of the transistor T. In this way, a single-side size of the memory cell 210 may reach 2F, so that an area of the entire memory cell 210 can reach 4F², thereby reducing the size of the memory cell 210, and further reducing sizes of the memory array 21 and the memory 20 having the memory array 21.

The following describes, by using an example, a structure of the electrical connection structure 40 that is configured to electrically connect two adjacent columnar capacitors 30 and a same transistor chain 2100. In some embodiments of this application, as shown in FIG. 8, the memory array 21 may further include a first insulation layer 51, and the first insulation layer 51 may cover the capacitor array 300 (as shown in FIG. 7). In addition, the electrical connection structure 40 may include a first via (via) 401, a second via 402, and a first conduction portion 403.

Still as shown in FIG. 8, the first via 401 may penetrate the first insulation layer 51, and a first end a1 of the first via 401 may be electrically connected to the second columnar electrode 302 of the first columnar capacitor 30a. The second via 402 penetrates the first insulation layer 51, and a first end a2 of the second via 402 may be electrically connected to the first columnar electrode 301 of the second columnar capacitor 30b. In addition, the first conduction portion 403 is disposed on a side that is of the first insulation layer 51 and that faces away from the capacitor array 300 (as shown in FIG. 7), and two ends of the first conduction portion 403 are respectively electrically connected to a second end b1 of the first via 401 and a second end b2 of the second via 402.

In this case, the first via 401 and the second via 402 may be manufactured on the first insulation layer 51. For example, as shown in FIG. 9 (a top view obtained in a direction A in FIG. 8), a vertical projection of the first via 401 on the capacitor array 300 (as shown in FIG. 7) may overlap at least a part of the second columnar electrode 302 of the first columnar capacitor 30a. In this way, the first end a1 of the first via 401 is electrically connected to the second columnar electrode 302 of the first columnar capacitor 30a.

Similarly, a vertical projection of the second via 402 on the capacitor array 300 (as shown in FIG. 7) may overlap at least a part of the first columnar electrode 301 of the second columnar capacitor 30b. In this way, the first end a2 of the second via 402 is electrically connected to the first columnar electrode 301 of the second columnar capacitor 30b. Next, the first via 401 is electrically connected to the second via 402 through the first conduction portion 403 that spans the first via 401 and the second via 402. In this way, the second columnar electrode 302 of the first columnar capacitor 30a may be indirectly electrically connected to the first columnar electrode 301 of the second columnar capacitor 30b sequentially through the first via 401, the first conduction portion 403, and the second via 402.

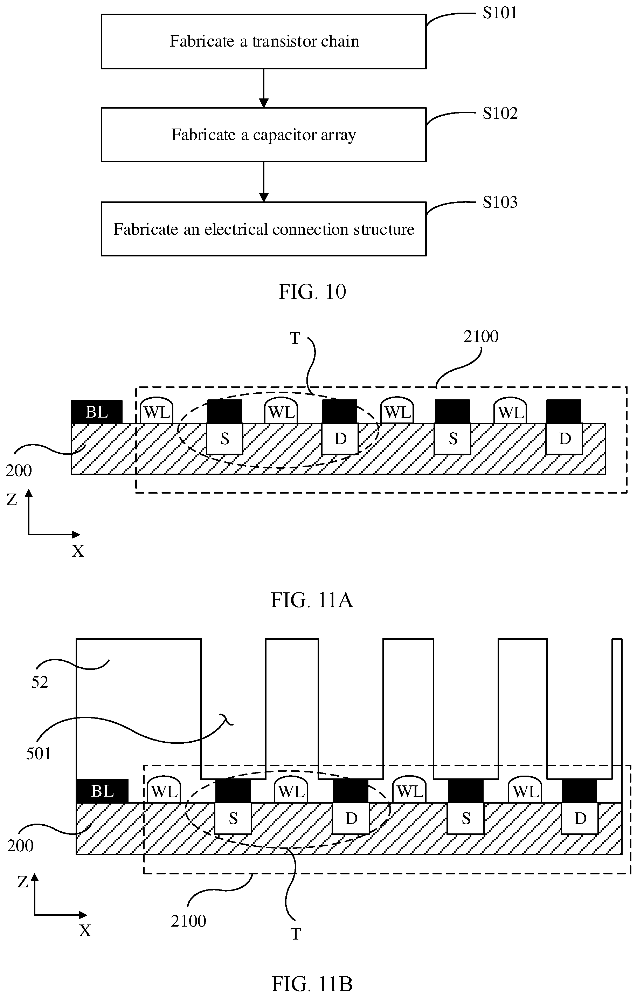

The following uses an example to describe the manufacturing method of the memory array 21 shown in FIG. 7. In some embodiments of this application, the manufacturing method of the memory array 21 may include S101 to S103 shown in FIG. 10.

S101: Fabricate a transistor chain.

For example, as shown in FIG. 11A, at least some of the plurality of transistors T are formed in the substrate 200, that is, the at least some of the transistors T are manufactured in the substrate 200. For example, a first electrode (for example, a source S) and a second electrode (for example, a drain D) of the transistor T may be formed by using a doping process in the substrate 200. The first electrode (for example, the source S) and the second electrode (for example, the drain D) are alternately disposed, so that first electrodes (for example, the source S) or second electrodes (for example, the drain D) of two adjacent transistors T are shared, and the two adjacent transistors T are connected in series, to form a transistor chain 2100. In addition, on the substrate 200, bit lines BL and contact portions 211 are manufactured, and the word line WL is fabricated at a position of the gate of the transistor T (or the word line WL is used as the gate of the transistor T).

In this case, at least a part of the transistor T located in the substrate 200 may be the first electrode (for example, the source S) and the second electrode (for example, the drain D) of the transistor T. Alternatively, in some other embodiments, the first electrode (for example, the source S), the second electrode (for example, the drain D) of the transistor T, and the word line WL used as the gate of the transistor T may all be disposed in the substrate 200. In this case, the entire transistor T is located in the substrate 200. This solution is explained and described in subsequent embodiments.

A manner in which the transistor T is disposed in the substrate 200 is not limited in this application. In addition, a manner in which the transistor T is disposed in the substrate 200 is unrelated to a manner in which, in the foregoing chain storage architecture, the electrical connection structure 40 connected in series to two adjacent columnar capacitors (for example, the first columnar capacitor 30a and the second columnar capacitor 30b) shown in FIG. 7 is disposed. In other words, a manner in which the electrical connection structure 40 is disposed in the memory array 21 is not affected by a manner in which the transistor T is disposed in the substrate 200.

S102: Fabricate a capacitor array.

For example, as shown in FIG. 11B, a second insulation layer 52 is formed on the substrate 200, and a via 501 is formed on the second insulation layer 52. A position of one via 501 may correspond to a position of a first electrode (for example, a source S) or a second electrode (for example, the drain D) of one transistor T. In other words, a vertical projection of the via 501 on the substrate 200 overlaps a vertical projection of the first electrode (for example, the source S) or the second electrode (for example, the drain D) corresponding to the via 501 on the substrate 200. In addition, the via 501 may expose the first electrode (for example, the source S) or the second electrode (for example, the drain D) of the transistor T.

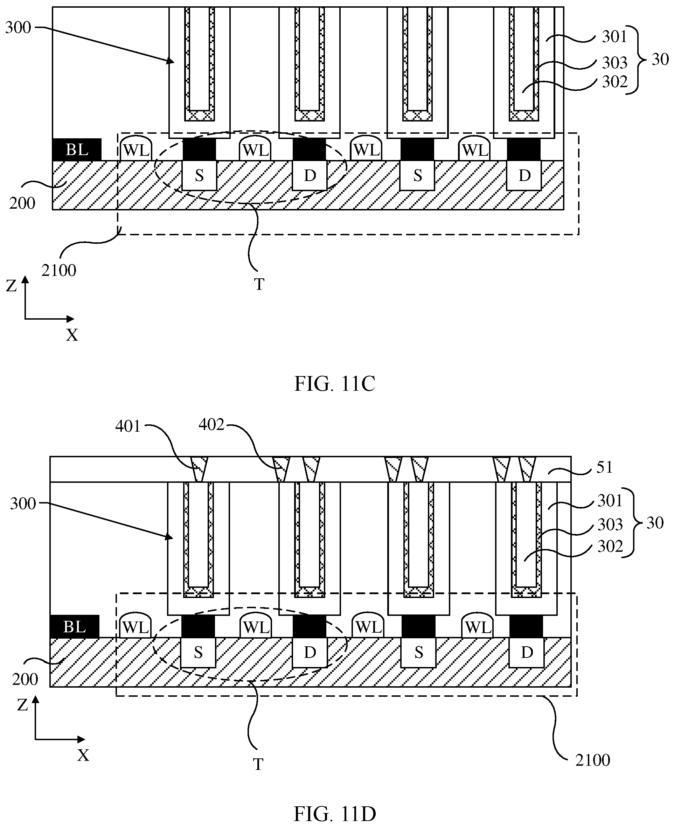

Next, as shown in FIG. 11C, a plurality of columnar capacitors 30 are formed in the via 501. For example, in the via 501, the first columnar electrode 301 is formed in a thin film deposition manner, for example, physical vapor deposition (physical vapor deposition, PVD), chemical vapor deposition (chemical vapor deposition, CVD), or atomic layer deposition (atomic layer deposition, ALD). The first columnar electrode 301 may be electrically connected to a first electrode (for example, a source S) or a second electrode (for example, a drain D) corresponding to a position of the first columnar electrode 301.

Then, still as shown in FIG. 11C, the dielectric layer 303 and the second columnar electrode 302 are sequentially formed in the first columnar electrode 301 by using the foregoing thin film deposition process, so that the dielectric layer 303 is located between the first columnar electrode 301 and the second columnar electrode 302. Because a position of one via 501 may correspond to a position of a first electrode (for example, a source S) or a second electrode (for example, a drain D) of one transistor T, a vertical projection of one columnar capacitor 30 on the transistor chain 2100 overlaps a first electrode (for example, source S) or a second electrode (for example, drain D) of one transistor T. Two electrodes (for example, the first columnar electrode 301 and the second columnar electrode 302) of the columnar capacitor 30 are respectively electrically connected to a first electrode (for example, a source S) and a second electrode (for example, a drain D) of one transistor T, to form a memory cell 210.

S103: Fabricate an electrical connection structure.

For example, as shown in FIG. 11D, a first insulation layer 51 and a plurality of first vias 401 and a plurality of second vias 402 that are located at the first insulation layer 51 are formed on a side that is of the plurality of columnar capacitors 30 and that faces away from the transistor chain 2100. The first via 401 and the second via 402 that are adjacent to each other are respectively electrically connected to the second columnar electrode 302 and the first columnar electrode 301 that are of the columnar capacitor 30 and that are adjacent to each other. Next, as shown in FIG. 8, a first conduction portion 403 is formed on a side that is of the first via 401 and the second via 402 and that faces away from the substrate 200, and two ends of the first conduction portion 403 are respectively electrically connected to the first via 401 and the second via 402 that are adjacent to each other.

In this way, the first via 401, the second via 402, and the first conduction portion 403 that are electrically connected to each other may form an electrical connection structure 40. Two ends of the electrical connection structure 40 may be respectively electrically connected to the second columnar electrode 302 of the adjacent first columnar capacitor 30a and the first columnar electrode 301 of the adjacent second columnar capacitor 30b, so that two adjacent columnar capacitors electrically connected to a same transistor chain 2100 are electrically connected through the electrical connection structure 40.

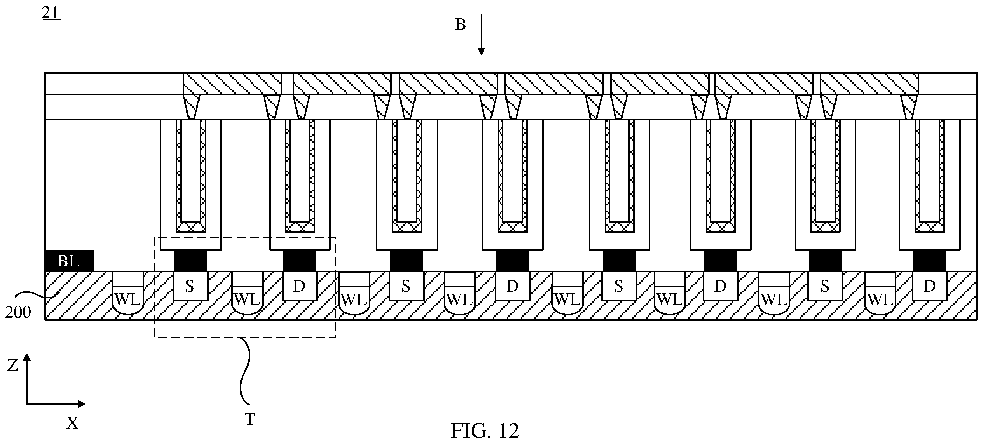

The foregoing is described by using an example in which the first electrode line, for example, the word line WL, in the memory array 21 shown in FIG. 7 is disposed on a surface of a side that is of the substrate 200 and that faces the capacitor array 300. In some other embodiments of this application, as shown in FIG. 12, the first electrode line, for example, the word line WL, may be disposed in the substrate 200. In this case, because the first electrode line, for example, the word line WL, is disposed on the gate of the transistor T and is used as the gate of the transistor T, a thickness of the word line WL may be increased when the word line WL is manufactured in a thickness direction of the substrate 200, namely, a Z direction. In this way, a length of a channel between the first electrode (for example, the source S) and the second electrode (for example, the drain D) of the transistor T may be increased. In addition, because the word line WL is located in the substrate 200, a size occupied by the word line WL in the Z direction of the entire memory array 21 can be reduced.

Based on this, the length of the gate of the transistor T in the Z direction can be increased by increasing the length of the first electrode line, for example, a length of the word line WL in the Z direction, so that a spacing between the first electrode (for example, the source S) and the second electrode (for example, the drain D) of the transistor T is reduced when it is ensured that performance (for example, a channel length) of the transistor T remains unchanged, thereby helping reduce a size of the entire memory array 21 on the XY plane. Alternatively, the length of the gate of the transistor T in the Z direction may be increased by increasing the length of the first electrode line, for example, the length of the word line WL in the Z direction, so that a length of the channel of the transistor T is increased when the spacing between the source and the drain of the transistor T remains unchanged, thereby helping to control on and off of the transistor T.

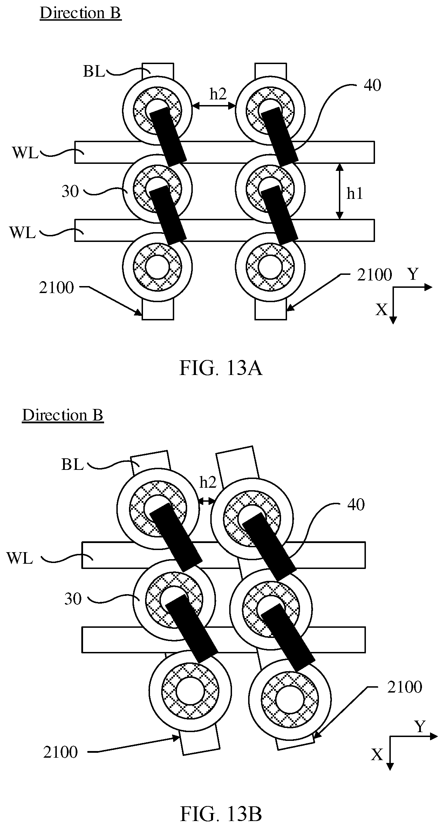

In addition, for any memory array 21 shown in FIG. 7 or FIG. 12, in the memory array 21, at least two transistor chains 2100 shown in FIG. 13A (a top view obtained in a direction B in FIG. 7 or FIG. 12) are electrically connected to a plurality of columnar capacitors 30, and may be arranged in a matrix manner. In this case, on a premise that a spacing h1 between two adjacent first electrode lines, for example, word lines WL, meets a process requirement, for example, a minimum processing size, a size of the columnar capacitor 30 on the XY plane may be reduced, to reduce a spacing h2 between columnar capacitors 30 respectively electrically connected to two adjacent transistor chains 2100. In this way, memory cells in the memory array can be arranged more closely, so that a memory having the memory array has a feature of high density.

Alternatively, in some other embodiments of this application, as shown in FIG. 13B (a top view obtained in a direction B in FIG. 7 or FIG. 12), the plurality of columnar capacitors 30 electrically connected to the at least two transistor chains 2100 may be arranged in a cellular manner. In this case, in the two adjacent transistor chains 2100, a columnar capacitor 30 electrically connected to one transistor chain 2100 may be located between two adjacent columnar capacitors 30 electrically connected to the other transistor chain 2100, so that arrangement of the plurality of transistor chains 2100 can be more compact. In addition, on a premise that a spacing h2 between columnar capacitors 30 respectively electrically connected to two adjacent transistor chains 2100 meets a process requirement, for example, a minimum processing size, a size of the columnar capacitor 30 on the XY plane may be increased. This helps increase a capacity of the memory array and a capacity of a memory having the memory array.

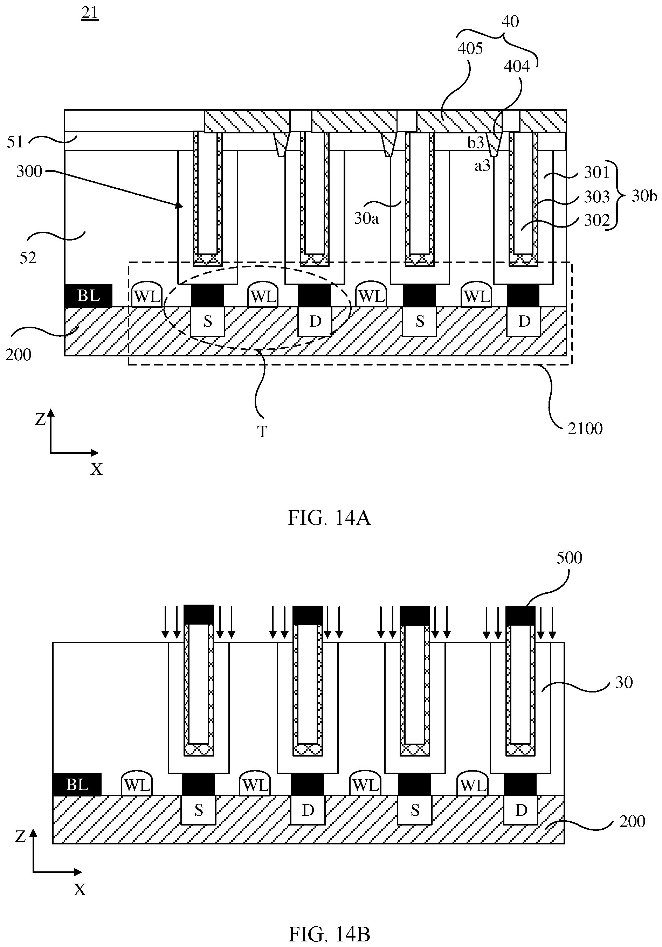

The foregoing uses an example in which the electrical connection structure 40 shown in FIG. 8 in the memory array 21 includes a first via 401, a second via 402, and a first conduction portion 403, and an electrical connection manner of two adjacent columnar capacitors 30 electrically connected to a same transistor chain 2100 in the memory array 21 is described by using an example. In some other embodiments of this application, as shown in FIG. 14A, in any one of the first columnar capacitor 30a and the second columnar capacitor 30b, an end that is of the second columnar electrode 302 and that faces the electrical connection structure 40 extends out of the first columnar electrode 301.

In addition, the memory array 21 may further include a first insulation layer 51 and a second insulation layer 52. The second insulation layer 52 is located on the side that is of the transistor chain 2100 and that faces away from the substrate 200, the capacitor array 300 is embedded in the second insulation layer 52, and there are two adjacent columnar capacitors, for example, at least a part of the second insulation layer 52 is disposed between the first columnar capacitor 30a and the second columnar capacitor 30b. The first insulation layer 51 is stacked on a side that is of the second insulation layer 52 and that faces away from the capacitor array 300, and covers the capacitor array 300. A material of the first insulation layer 51 may be the same as or different from a material of the second insulation layer 52. This is not limited in this application.

On this basis, still as shown in FIG. 14A, the electrical connection structure 40 may include a third via 404 and second conduction portions 405. The third via 404 is disposed in the first insulation layer 51, and a first end a3 of the third via 404 is electrically connected to the first columnar electrode 301 of the second columnar capacitor 30b. A vertical projection of the third via 404 on the capacitor array 300 may overlap at least a part of the first columnar electrode 301 of the second columnar electrode 30b. In this way, the first end a3 of the third via 404 is electrically connected to the first columnar electrode 301 of the second columnar electrode 30b.

In addition, still as shown in FIG. 14A, the second conduction portion 405 is disposed on a side that is of the first insulation layer 51 and that faces away from the capacitor array 300, and two ends of the second conduction portion 405 may be respectively electrically connected to an end that is of the second columnar electrode 302 of the first columnar capacitor 30a and that faces the electrical connection structure 40 and a second end b3 of the third via 404. In this way, the second columnar electrode 302 of the first columnar capacitor 30a may be indirectly electrically connected to the first columnar electrode 301 of the second columnar capacitor 30b sequentially through the second conduction portion 405 and the third via 404.

In addition, it can be learned from FIG. 14A that only one via, namely, the third via 404, is disposed between the two adjacent columnar capacitors electrically connected to the same transistor chain 2100, for example, the first columnar capacitor 30a and the second columnar capacitor 30b. Therefore, a spacing between two adjacent third vias 404 is large, and a requirement on precision of a photolithography process for manufacturing the third vias 404 is low, so that manufacturing processes of the memory array and the memory can be simplified. The photolithography process may include a process used to form a film layer pattern, for example, exposure, development, and etching.

It can be learned from the foregoing that, still as shown in FIG. 14A, in any one of the first columnar capacitor 30a and the second columnar capacitor 30b, an end that is of the second columnar electrode 302 and that faces the electrical connection structure 40 needs to extend out of the first columnar electrode 301, so as to be electrically connected to the second conduction portion 405. Based on this, as shown in FIG. 14B, in a process of manufacturing the columnar capacitor 30, a hard mask (hard mask) 500 may be covered on a surface of a side that is of the second columnar electrode 302 and that faces away from the substrate 200. In this way, in a process of etching the first columnar electrode 301 in a direction indicated by arrows by using the etching process, the hard mask 500 can protect the second columnar electrode 302 from being etched, so that the second columnar electrode 302 can extend out of the first columnar electrode 301. After the first columnar electrode 301 is etched, the hard mask 500 may be removed. Alternatively, when the hard mask 500 is a conductive material, the hard mask 500 may be retained as a part of the second columnar electrode 302. This is not limited in this application.

In addition, a manufacturing method of another component in the memory array 21 shown in FIG. 14A is similar to the manufacturing method of the memory array 21 shown in FIG. 7. Details are not described herein again.

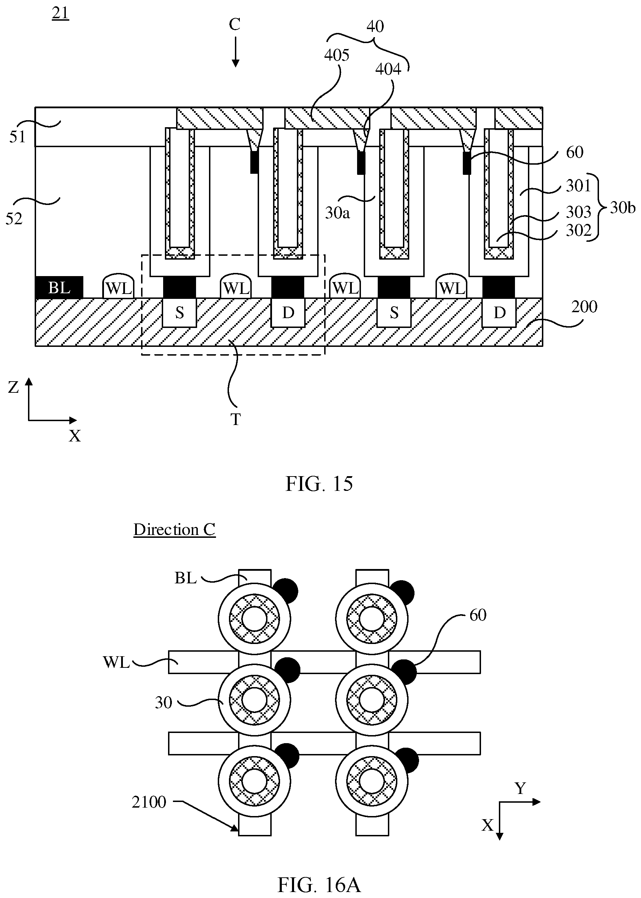

Alternatively, in some other embodiments of this application, to facilitate the electrical connection structure 40 to connect the first columnar capacitor 30a and the second columnar capacitor 30b in series, as shown in FIG. 15, the memory array 21 may further include electrical connection columns 60. The electrical connection column 60 may be disposed in the second insulation layer 52, and the electrical connection column 60 may be located on a side that is of the third via 404 and that faces away from the second conduction portion 405. For example, as shown in FIG. 16A (a top view obtained in a direction C in FIG. 15), there is a large gap between adjacent transistor chains 2100. Therefore, the electrical connection column 60 may be located between the adjacent transistor chains 2100, so that an area occupied by the electrical connection column 60 on the XY surface can be reduced.

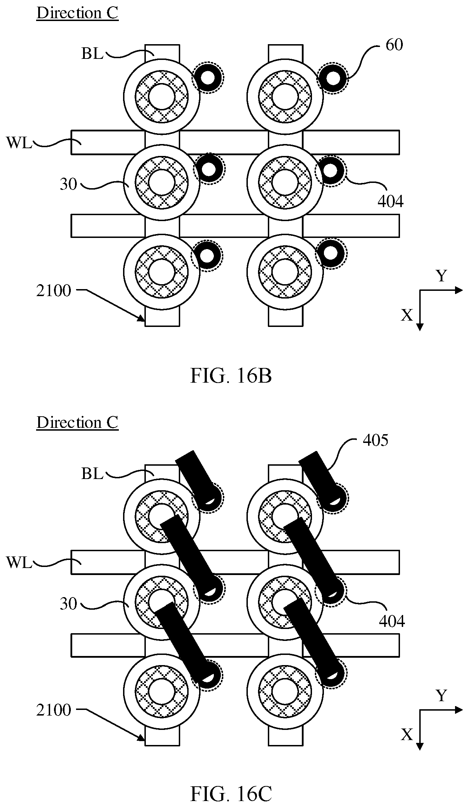

In addition, the electrical connection column 60 may be electrically connected to a side wall of the first columnar electrode 301 and the third via 404. For example, as shown in FIG. 16B (a top view obtained in a direction C in FIG. 15), after the electrical connection column 60 is fabricated, the third via 404 may be fabricated, so that a vertical projection of the third via 404 on the substrate 200 (as shown in FIG. 15) may cover a vertical projection of the electrical connection column 60 on the substrate 200 (as shown in FIG. 15), so that the third via 404 is electrically connected to the electrical connection column 60.

Next, as shown in FIG. 16C (a top view obtained in a direction C in FIG. 15), the second conduction portion 405 is formed, so that a second columnar electrode 302 of one of two adjacent columnar capacitors 30 indirectly electrically connect to the first columnar electrode 301 of the other columnar capacitor 30 sequentially through the second conduction portion 405, the third via 404, and the electrical connection column 60. In this way, because the electrical connection column 60 is electrically connected to the side wall of the first columnar electrode 301, a probability of an electrical connection between the third via 404 and the first columnar electrode 301 can be increased via the electrical connection column 60, to ensure reliability of the electrical connection.

In addition, a manufacturing method of another component in the memory array 21 shown in FIG. 15 is similar to the manufacturing method of the memory array 21 shown in FIG. 7. Details are not described herein again.

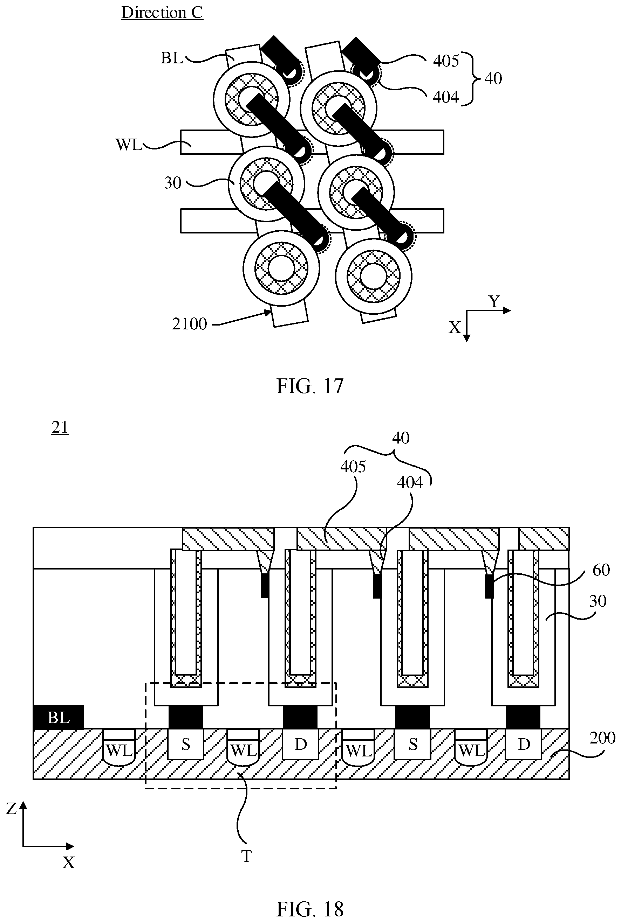

On this basis, FIG. 16C is described by using an example in which a plurality of columnar capacitors 30 electrically connected to at least two transistor chains 2100 in the memory array are arranged in a matrix manner. In some other embodiments, as shown in FIG. 17 (a top view obtained in a direction C in FIG. 15), a plurality of columnar capacitors 30 electrically connected to at least two transistor chains 2100 in the memory array may be arranged in a cellular manner. Technical effect of the foregoing matrix arrangement and cellular arrangement is the same as that described above. Details are not described herein again.

In addition, the foregoing is described by using an example in which the first electrode line, for example, the word line WL, in the memory array 21 shown in FIG. 15 is disposed on a surface of a side that is of the substrate 200 and that faces the capacitor array 300. In some other embodiments of this application, as shown in FIG. 18, the first electrode line, for example, the word line WL, may be disposed in the substrate 200. In addition, the first electrode line in FIG. 14A, for example, the word line WL, may also be disposed in the substrate 200. Technical effect in which the word line WL is disposed in the substrate 200 is the same as that described above. Details are not described herein again.

The foregoing describes a manner in which two adjacent columnar capacitors electrically connected to a same transistor chain 2100 are connected in series through the electrical connection structure 40. For example, the second columnar electrode 302 of the first columnar capacitor 30a is electrically connected to the first columnar electrode 301 of the second columnar capacitor 30b through the electrical connection structure 40, and a manner in which the first columnar capacitor 30a is electrically connected to the second columnar capacitor 30b is used as an example for description.

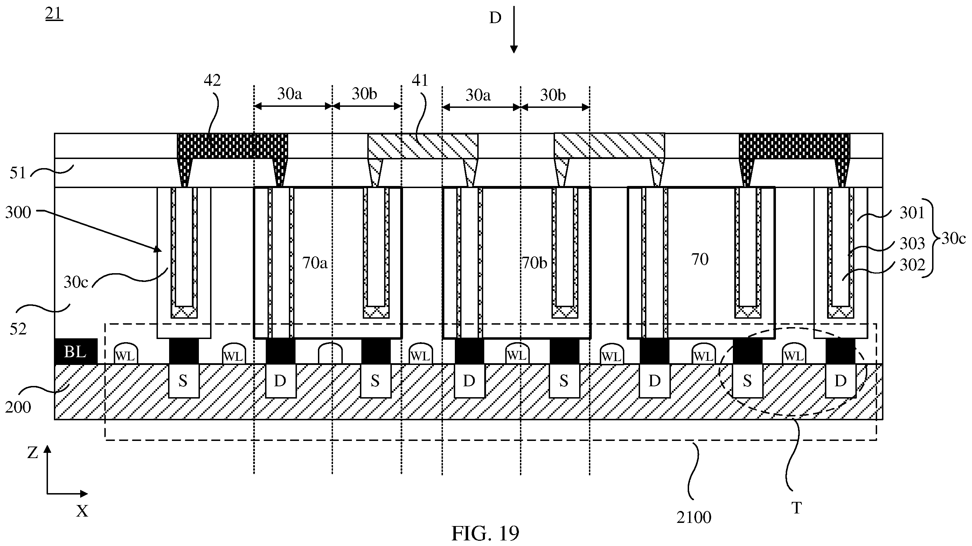

In some other embodiments of this application, two adjacent columnar capacitors electrically connected to a same transistor chain 2100 are connected in series through an electrical connection structure 40. As shown in FIG. 19, in the memory array 21, two adjacent columnar capacitors are electrically connected to a same transistor chain 2100, for example, a first columnar capacitor 30a and a second columnar capacitor 30b are used. A first columnar electrode 301 of the first columnar capacitor 30a and a first columnar electrode 301 of the second columnar capacitor 30b are connected to form an integrated mechanical member 70. Adjacent integrated mechanical members are a first integrated mechanical member 70a and a second integrated mechanical member 70b.

On this basis, still as shown in FIG. 19, an end that is of the integrated mechanical member 70 and that faces the transistor chain 2100 is electrically connected to the first electrode (for example, the source S) of the transistor T, so that one electrode of the transistor T that is configured to form the memory cell, for example, the source S, can be electrically connected to one electrode of the columnar capacitor, for example, the first columnar electrode 301.

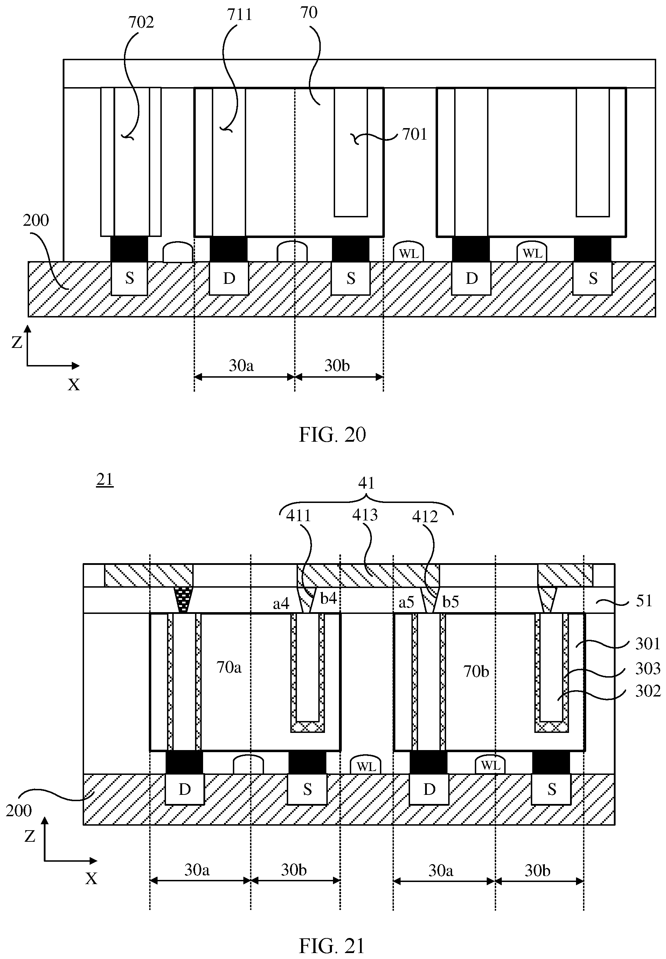

In addition, a side that is of the integrated mechanical member 70 and that faces away from the transistor chain 2100 is provided with a first blind via 701 shown in FIG. 20, and the second columnar electrode 302 of the second columnar capacitor 30b shown in FIG. 19 is located in the first blind via 701. On this basis, still as shown in FIG. 19, the at least one electrical connection structure may include a first electrical connection structure 41.

In adjacent integrated mechanical members, the second columnar electrode 302 of the second columnar capacitor 30b in the first integrated mechanical member 70a and the second columnar electrode 302 of the first columnar capacitor 30a in the second integrated mechanical member 70b are respectively electrically connected to two ends of the first electrical connection structure 41. The second columnar electrode 302 of the first columnar capacitor 30a penetrates the second integrated mechanical member 70b, and the second columnar electrode 302 of the first columnar capacitor 30a is electrically connected to the second electrode (for example, the drain D) of the transistor T.

In this way, the other electrode of the transistor T configured to form the memory cell, for example, the drain D, may be electrically connected to the other electrode of the columnar capacitor, for example, the second columnar electrode 302. In addition, two adjacent columnar capacitors that are electrically connected to a same transistor chain 2100 and that have different integrated mechanical members 70 may be further connected in series through the first electrical connection structure 41.

In some embodiments of this application, a structure of the first electrical connection structure 41 may be shown in FIG. 21. The first electrical connection structure 41 may include a fourth via 411, a fifth via 412, and a third conduction portion 413. The fourth via 411 penetrates the first insulation layer 51, and a first end a4 of the fourth via 411 is electrically connected to the second columnar electrode 302 of the second columnar capacitor 30b in the first integrated mechanical member 70a. The fifth via 412 penetrates the first insulation layer 51, and a first end a5 of the fifth via 412 is electrically connected to the second columnar electrode 302 of the first columnar capacitor 30a in the second integrated mechanical member 70b. In addition, the third conduction portion 413 may be disposed on a side that is of the first insulation layer 51 and that faces away from the capacitor array 300 (as shown in FIG. 19). Two ends of the third conduction portion 413 are respectively electrically connected to a second end b4 of the fourth via 411 and a second end b5 of the fifth via 412.

In this way, in adjacent integrated mechanical members, the second columnar electrode 302 of the second columnar capacitor 30b in the first integrated mechanical member 70a may be electrically connected to the second columnar electrode 302 of the first columnar capacitor 30a in the second integrated mechanical member 70b sequentially through the fourth via 411, the third conduction portion 413, and the fifth via 412.

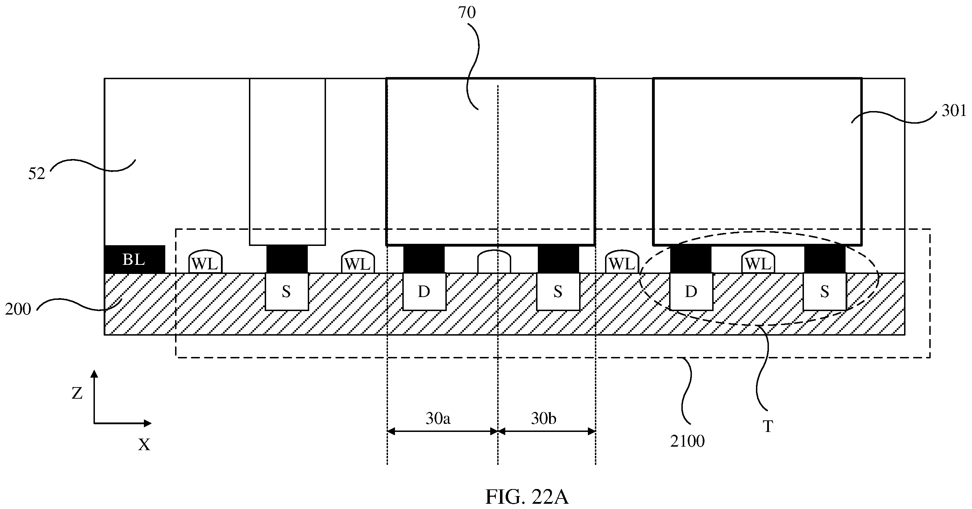

The following uses an example to describe the manufacturing method of the memory array 21 shown in FIG. 19. For example, the manufacturing method may also include S101 to S103 shown in FIG. 10. S101 is the same as that described above. Details are not described herein again. In a process of performing S102, as shown in FIG. 22A, the first columnar electrode 301 of the first columnar capacitor 30a and the first columnar electrode 301 of the second columnar capacitor 30b may be formed, and the first columnar electrode 301 of the first columnar capacitor 30a and the first columnar electrode 301 of the second columnar capacitor 30b are connected to form an integrated mechanical member 70.

For example, still as shown in FIG. 19, a via may be formed in the second insulation layer 52, and the via may expose the first electrode (for example, the source S) of the transistor T. Then, an integrated mechanical member 70 is formed in the blind via by using the same thin film deposition process, and an end that is of the integrated mechanical member 70 and that faces the transistor chain 2100 is electrically connected to the first electrode (for example, the source S) of the transistor T. A part of the integrated mechanical member 70 may be used as the first columnar electrode 301 of the first columnar capacitor 30a, and the other part may be used as the first columnar electrode 301 of the second columnar capacitor 30b.

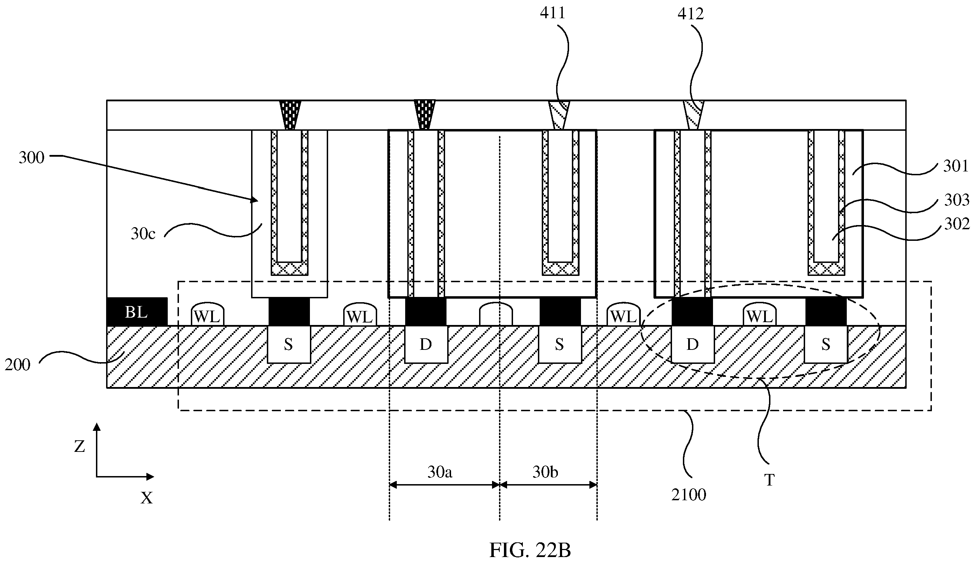

Next, a through hole 711 (as shown in FIG. 20) that penetrates the integrated mechanical member 70 is manufactured in the integrated mechanical member 70, the second columnar electrode 302 of the first columnar capacitor 30a shown in FIG. 22B is formed in the through hole 711, and the second columnar electrode 3302 is electrically connected to the second electrode (for example, the drain D) of the transistor T. In addition, a first blind via 701 shown in FIG. 20 is formed on a side that is of the integrated mechanical member 70 and that faces away from the transistor chain 2100, and the second columnar electrode 302 of the second columnar capacitor 30b shown in FIG. 22B is formed in the first blind via 701.

Next, in a process of performing S103, as shown in FIG. 22B, at least the fourth via 411 and the fifth via 412 may be formed on a side that is of the plurality of columnar capacitors and that faces away from the transistor chain 2100 (as shown in FIG. 19). In addition, the third conduction portion 413 that is shown in FIG. 21 and that is configured to electrically connect the fourth via 411 and the fifth via 412 is formed above the fourth via 411 and the fifth via 412. Still as shown in FIG. 21, two ends of the first electrical connection structure 41 mainly including the fourth via 411, the fifth via 412, and the third conduction portion 413 are respectively electrically connected to the second columnar electrode 301 of the second columnar capacitor 30b and the second columnar electrode 302 of the first columnar capacitor 30a in adjacent integrated mechanical members 70.

On this basis, still as shown in FIG. 19, in the transistor chain 2100, the columnar capacitor electrically connected to the transistor T at the tail end or the head end may be a third columnar capacitor 30c. A side that is of the third columnar capacitor 30c and that faces away from the transistor chain 2100 is provided with a second blind via 702 shown in FIG. 20. A second columnar electrode 302 of the third columnar capacitor 30c shown in FIG. 19 is located in the second blind via 702.

Based on this, still as shown in FIG. 19, the at least one electrical connection structure further includes a second electrical connection structure 42. The second columnar electrode 302 of the third columnar capacitor 30c and the second columnar electrode 302 of the adjacent first columnar capacitor 30a or second columnar capacitor 30b are respectively electrically connected to two ends of the second electrical connection structure 42. In this way, the third columnar capacitor 30c may be electrically connected to the first columnar capacitor 30a or the second columnar capacitor 30b adjacent to the third columnar capacitor 30c through the second electrical connection structure 42. A structure of the second electrical connection structure 42 may be similar to that of the first connection structure 41. Details are not described herein again.

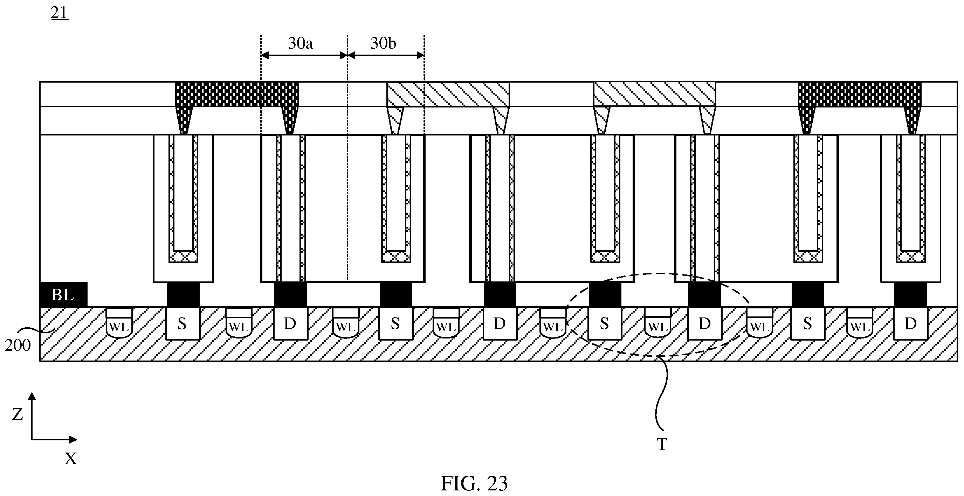

The foregoing is described by using an example in which the first electrode line, for example, the word line WL, in the memory array 21 shown in FIG. 19 is disposed on a surface of a side that is of the substrate 200 and that faces the capacitor array 300. In some other embodiments of this application, as shown in FIG. 23, the first electrode line, for example, the word line WL, may be disposed in the substrate 200. Technical effect in which the word line WL is disposed in the substrate 200 is the same as that described above. Details are not described herein again.

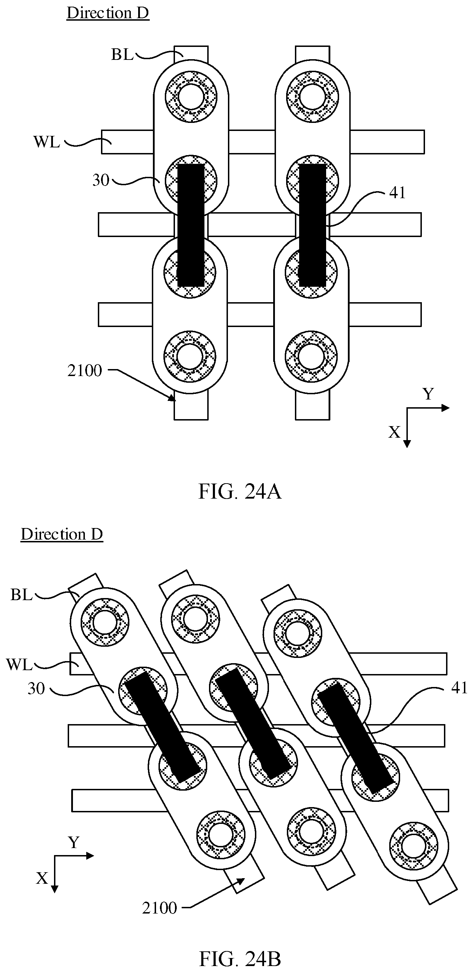

On this basis, FIG. 24A (a top view obtained in a direction D in FIG. 19) is described by using an example in which a plurality of columnar capacitors 30 electrically connected to at least two transistor chains 2100 in the memory array are arranged in a matrix manner. In some other embodiments, as shown in FIG. 24B (a top view obtained in a direction D in FIG. 19), a plurality of columnar capacitors 30 electrically connected to at least two transistor chains 2100 in the memory array may be arranged in a cellular manner. Technical effect of the foregoing matrix arrangement and cellular arrangement is the same as that described above. Details are not described herein again.

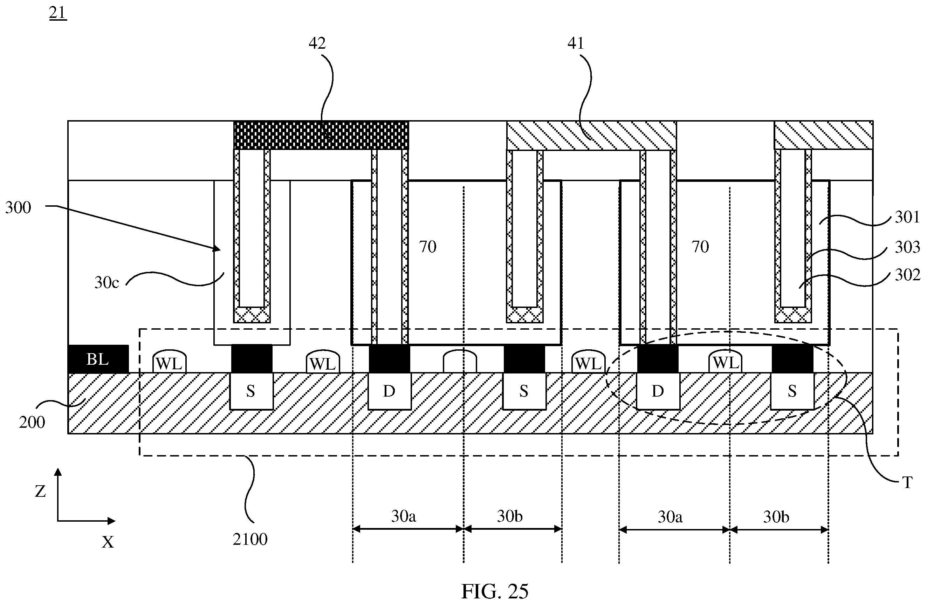

The foregoing uses an example in which the first electrical connection structure 41 shown in FIG. 21 in the memory array 21 includes the fourth via 411, the fifth via 412, and the third conduction portion 413, and an electrical connection manner of two adjacent columnar capacitors that are electrically connected to a same transistor chain 2100 in the memory array 21 and that do not have a same integrated mechanical member 70 is described by using an example. In some other embodiments of this application, as shown in FIG. 25, in any columnar capacitor, an end that is of the second columnar electrode 302 and that faces away from the transistor chain 2100 extends out of the first columnar electrode 301.

Based on this, two ends of the first electrical connection structure 41 may be respectively electrically connected to ends that are of two adjacent second columnar electrodes 302 in different integrated mechanical members 70 and that face away from the transistor chain 2100. In this way, two adjacent columnar capacitors having different integrated structures 70, for example, the first columnar capacitor 30a and the second columnar capacitor 30b, may be connected in series through the first electrical connection structure 41.

Similarly, still as shown in FIG. 25, the second columnar electrode 302 of the third columnar capacitor 30c may extend out of the first columnar electrode 301 of the third columnar capacitor 30c, and the second columnar electrode 302 of the adjacent first columnar capacitor 30a or second columnar capacitor 30b extends out of the first columnar electrode 301. In this case, the second electrical connection structure 42 may be electrically connected to an extended part of the second columnar electrode 302 of the third columnar capacitor 30c and a part that is of the second columnar electrode 302 of the adjacent first columnar capacitor 30a or second columnar capacitor 30b and that extends out of the first columnar electrode 301.

In this way, both the first electrical connection structure 41 and the second electrical connection structure 42 may be metal thin film layers manufactured above the capacitor array 300. Therefore, there is no need to manufacture a via to connect adjacent columnar capacitors in series, so that manufacturing processes of the memory array and the memory can be simplified.

An arrangement manner of the columnar capacitors in the memory array 21 shown in FIG. 25 and a manufacturing method of the memory array 21 are the same as those described above. Details are not described herein again. In addition, the first electrode line in FIG. 25, for example, the word line WL, may also be manufactured in the substrate 200. Beneficial effect of the foregoing structure is the same as that described above. Details are not described herein again.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A memory array, comprising:
a substrate;
at least two transistor chains, wherein at least a part of the transistor chain is disposed in the substrate, the transistor chain comprises a plurality of transistors connected in series, and in a same transistor chain, first electrodes or second electrodes of two adjacent transistors are shared, to enable the two adjacent transistors to be connected in series;
a capacitor array, stacked on a side that is of the transistor chain and that faces away from the substrate, wherein the capacitor array comprises a plurality of columnar capacitors, a vertical projection of one columnar capacitor on the transistor chain at least partially overlaps a first electrode or a second electrode of one transistor, and two electrodes of the columnar capacitor are respectively electrically connected to the first electrode and the second electrode of the transistor, to form a memory cell; and
at least one electrical connection structure, stacked on a side that is of the capacitor array and that faces away from the transistor chain, wherein electrodes of two adjacent columnar capacitors electrically connected to a same transistor chain are respectively electrically connected to two ends of the electrical connection structure, to enable the two adjacent columnar capacitors to be connected in series through the electrical connection structure.

2. The memory array according to claim 1, wherein
the columnar capacitor comprises:
a first columnar electrode, wherein an end facing the transistor chain is electrically connected to the first electrode or the second electrode of the transistor;
a second columnar electrode, wherein at least a part of the second columnar electrode is disposed in the first columnar electrode; and
a dielectric layer, wherein at least a part of the dielectric layer is disposed in the first columnar electrode, and the dielectric layer is located between the first columnar electrode and the second columnar electrode, wherein
the two adjacent columnar capacitors electrically connected to the same transistor chain are a first columnar capacitor and a second columnar capacitor, two ends of the electrical connection structure are respectively electrically connected to the second columnar electrode of the first columnar capacitor and the first columnar electrode of the second columnar capacitor.

3. The memory array according to claim 2, wherein
the memory array further comprises a first insulation layer, and the first insulation layer covers the capacitor array; and
the electrical connection structure comprises:
a first via, penetrating the first insulation layer, wherein a first end of the first via is electrically connected to the second columnar electrode of the first columnar capacitor;
a second via, penetrating the first insulation layer, wherein a first end of the second via is electrically connected to the first columnar electrode of the second columnar capacitor; and
a first conduction portion, disposed on a side that is of the first insulation layer and that faces away from the capacitor array, wherein two ends of the first conduction portion are respectively electrically connected to a second end of the first via and a second end of the second via.

4. The memory array according to claim 2, wherein in any one of the first columnar capacitor and the second columnar capacitor, an end that is of the second columnar electrode and that faces the electrical connection structure extends out of the first columnar electrode; and
the memory array further comprises a first insulation layer, and the first insulation layer covers the capacitor array; and
the electrical connection structure comprises:
a third via, penetrating the first insulation layer, wherein a first end of the third via is electrically connected to the first columnar electrode of the second columnar capacitor; and
a second conduction portion, disposed on a side that is of the first insulation layer and that faces away from the capacitor array, wherein two ends of the second conduction portion are respectively electrically connected to an end that is of the second columnar electrode of the first columnar capacitor and that faces the electrical connection structure and a second end of the third via.

5. The memory array according to claim 4, wherein
the memory array further comprises:
a second insulation layer, disposed on the side that is of the transistor chain and that faces away from the substrate, wherein the capacitor array is embedded in the second insulation layer; and
an electrical connection column, disposed in the second insulation layer, wherein the electrical connection column is located on a side that is of the third via and that faces away from the second conduction portion, and the electrical connection column is electrically connected to a side wall of the first columnar electrode and the third via.

6. The memory array according to claim 2, wherein
the columnar capacitor comprises:
a first columnar electrode;
a second columnar electrode, wherein at least a part of the second columnar electrode is disposed in the first columnar electrode; and
a dielectric layer, wherein at least a part of the dielectric layer is disposed in the first columnar electrode, and the dielectric layer is located between the first columnar electrode and the second columnar electrode, wherein
the two adjacent columnar capacitors electrically connected to the same transistor chain are a first columnar capacitor and a second columnar capacitor, and the first columnar electrode of the first columnar capacitor and the first columnar electrode of the second columnar capacitor are connected to form an integrated mechanical member;
an end that is of the integrated mechanical member and that faces the transistor chain is electrically connected to the first electrode of the transistor, and the second columnar electrode of the first columnar capacitor penetrates the integrated mechanical member and is electrically connected to the second electrode of the transistor;
a side that is of the integrated mechanical member and that faces away from the transistor chain is provided with a first blind via, and the second columnar electrode of the second columnar capacitor is located in the first blind via; and
the at least one electrical connection structure comprises a first electrical connection structure; and in the adjacent integrated mechanical member, the second columnar electrode of the second columnar capacitor and the second columnar electrode of the first columnar capacitor are respectively electrically connected to two ends of the first electrical connection structure.

7. The memory array according to claim 6, wherein
the memory array further comprises a first insulation layer, and the first insulation layer covers the capacitor array; and
the adjacent integrated mechanical member is a first integrated mechanical member and a second integrated mechanical member, and the first electrical connection structure comprises:
a fourth via, penetrating the first insulation layer, wherein a first end of the fourth via is electrically connected to the second columnar electrode of the second columnar capacitor in the first integrated mechanical member;
a fifth via, penetrating the first insulation layer, wherein a first end of the fifth via is electrically connected to the second columnar electrode of the first columnar capacitor in the second integrated mechanical member; and
a third conduction portion, disposed on a side that is of the first insulation layer and that faces away from the capacitor array, wherein two ends of the third conduction portion are respectively electrically connected to a second end of the fourth via and a second end of the fifth via.

8. The memory array according to claim 6, wherein
in the columnar capacitor, an end that is of the second columnar electrode and that faces away from the transistor chain extends out of the first columnar electrode; and
the capacitor array comprises a plurality of integrated mechanical members, and two ends of the first electrical connection structure are respectively electrically connected to ends that are of two adjacent second columnar electrodes in different integrated mechanical members and that face away from the transistor chain.

9. The memory array according to any one of claims 6 to 8, wherein
in the transistor chain, a columnar capacitor electrically connected to the transistor at the tail end or the head end is a third columnar capacitor;
a side that is of the third columnar capacitor and that faces away from the transistor chain is provided with a second blind via, and the second columnar electrode of the third columnar capacitor is located in the second blind via; and
the at least one electrical connection structure further comprises a second electrical connection structure, and the second columnar electrode of the third columnar capacitor and the second columnar electrode of the adjacent first columnar capacitor or second columnar capacitor are respectively electrically connected to two ends of the second electrical connection structure.

10. The memory array according to any one of claims 2 to 9, wherein the dielectric layer comprises a ferroelectric thin film layer or a resistive switching layer.

11. The memory array according to any one of claims 1 to 10, wherein
the first electrode or the second electrode of the transistor is located within a range of the vertical projection of the columnar capacitor on the transistor chain.

12. The memory array according to any one of claims 1 to 11, wherein the first electrode and the second electrode of the transistor are disposed in the substrate; and the memory array further comprises:
a first electrode line, electrically connected to a gate of the transistor, wherein the first electrode line is disposed on a surface of a side that is of the substrate and that faces the capacitor array; or the first electrode line is disposed in the substrate.

13. The memory array according to claim 12, wherein the memory array further comprises:
a second electrode line, wherein a first end of the transistor chain is electrically connected to the second electrode line; and
a third electrode line, electrically connected to second ends of the at least two transistor chains.

14. The memory array according to any one of claims 1 to 13, wherein
the memory array further comprises:
a contact portion, disposed between the transistor chain and the capacitor array, wherein the contact portion is electrically connected to an electrode of the columnar capacitor and the first electrode or the second electrode of the transistor.

15. The memory array according to any one of claims 1 to 14, wherein
the plurality of columnar capacitors electrically connected to the at least two transistor chains are arranged in a matrix manner;
or
the plurality of columnar capacitors electrically connected to the at least two transistor chains are arranged in a cellular manner.

16. A memory, comprising:
the memory array according to any one of claims 1 to 15; and
a controller, wherein the controller is electrically connected to the memory array, and the controller is configured to control read/write of the memory array.

17. An electronic device, comprising:
a circuit board; and
the memory according to claim 16, wherein the circuit board is electrically connected to the memory.

18. A manufacturing method of a memory array, comprising:
forming at least a part of a plurality of transistors in a substrate, wherein first electrodes or second electrodes of two adjacent transistors are shared, to enable the two adjacent transistors to be connected in series, to form a transistor chain;
forming a plurality of columnar capacitors, wherein a vertical projection of one columnar capacitor on the transistor chain at least partially overlaps a first electrode or a second electrode of one transistor; and two electrodes of the columnar capacitor are respectively electrically connected to the first electrode and the second electrode of the transistor, to form a memory cell; and
forming at least one electrical connection structure on a side that is of the plurality of columnar capacitors and that faces away from the transistor chain, wherein two ends of the electrical connection structure are respectively electrically connected to electrodes of two adjacent columnar capacitors electrically connected to a same transistor chain, to enable the two adjacent columnar capacitors to be connected in series through the electrical connection structure.

19. The manufacturing method of the memory array according to claim 18, wherein
forming any one of the plurality of columnar capacitors comprises:
forming a first columnar electrode;
forming a dielectric layer in the first columnar electrode; and
forming a second columnar electrode in the dielectric layer, wherein the dielectric layer is located between the first columnar electrode and the second columnar electrode; and
the two adjacent columnar capacitors electrically connected to the same transistor chain are a first columnar capacitor and a second columnar capacitor; and forming the electrical connection structure comprises:
respectively electrically connecting two ends of the electrical connection structure to the second columnar electrode of the first columnar capacitor and the first columnar electrode of the second columnar capacitor.

20. The manufacturing method of the memory array according to claim 18, wherein
the two adjacent columnar capacitors electrically connected to the same transistor chain are a first columnar capacitor and a second columnar capacitor, and forming the first columnar capacitor and the second columnar capacitor comprises:
forming a first columnar electrode of the first columnar capacitor and a first columnar electrode of the second columnar capacitor, and connecting the first columnar electrode of the first columnar capacitor and the first columnar electrode of the second columnar capacitor to form an integrated mechanical member;
electrically connecting an end that is of the integrated mechanical member and that faces the transistor chain to the first electrode of the transistor;
manufacturing, in the integrated mechanical member, a through hole that penetrates the integrated mechanical member, forming a second columnar electrode of the first columnar capacitor in the through hole, and electrically connecting the second columnar electrode to the second electrode of the transistor;
forming a first blind via on a side that is of the integrated mechanical member and that faces away from the transistor chain, and forming the second columnar electrode of the second columnar capacitor in the first blind via; and
forming the at least one electrical connection structure comprises: forming a first electrical connection structure on a side that is of the plurality of columnar capacitors and that faces away from the transistor chain, and respectively connecting two ends of the first electrical connection structure to the second columnar electrode of the second columnar capacitor and the second columnar electrode of the first columnar capacitor in the adjacent integrated mechanical member.
